# EUROPEAN PATENT APPLICATION

(11) **EP 4 708 727 A1**
(43) Date of publication of application: **11.03.2026**
(21) Application number: 24824975.7
(22) Date of filing: 02.04.2024
(51) Int. Cl.: H04B 10/25

(54) **DATA TRANSMISSION METHOD, APPARATUS AND SYSTEM**

(30) Priority: 21.06.2023 CN 202310748877
(71) Applicant: Huawei Technologies Co., Ltd., Shenzhen, Guangdong 518129 (CN)
(72) Inventor: HUANG, Qinhui, Shenzhen, Guangdong 518129 (CN); HUANG, Kechao, Shenzhen, Guangdong 518129 (CN); LIN, Youxi, Shenzhen, Guangdong 518129 (CN); YANG, Xiaoling, Shenzhen, Guangdong 518129 (CN); MA, Huixiao, Shenzhen, Guangdong 518129 (CN)
(74) Representative: Körber, Martin Hans
(86) International application number: PCT/CN2024/085620
(87) International publication number: WO 2024/260073

(57) **Abstract**

A data transmission method, an apparatus, and a system are provided, and relate to the field of optical communication technologies, to provide an inner-code processing solution applicable to a plurality of application scenarios. In embodiments of this application, an optical module of a transmitter may select one inner-code processing mode from a plurality of inner-code processing modes based on a requirement, and indicate the inner-code processing mode to an optical module of a receiver. The selected inner-code processing mode may be indicated to the receiver by using a PAD sequence, without requiring an additional resource and without changing a baud rate of a data stream. In some possible implementation solutions, the optical module of the receiver may also detect quality of a current link, to select an inner-code processing mode that matches the quality, and feed back the inner-code processing mode to the transmitter, so that the transmitter can switch the inner-code processing mode based on an indication. In addition, when the transmitter chooses to skip inner-code processing, a host may indicate the optical module to directly skip the inner-code processing, and the receiver may determine, through rate detection, whether to skip the inner-code processing currently.

## Description

### CROSS-REFERENCE TO RELATED APPLICATIONS

This application claims priority to Chinese Patent Application No. 202310748877.8, filed with the China National Intellectual Property Administration on June 21, 2023 and entitled "DATA TRANSMISSION METHOD, APPARATUS, AND SYSTEM", which is incorporated herein by reference in its entirety.

### TECHNICAL FIELD

This application relates to the field of optical communication technologies, and in particular, to a data transmission method, an apparatus, and a system.

### BACKGROUND

Continuously driven by 5G, cloud computing, big data, artificial intelligence, and the like, optical communication systems and optical transport networks (optical transport networks, OTNs) are developing toward large capacities and ultra-high speeds. Transmitted data is corrected through forward error correction (forward error correction, FEC) encoding, so that bit errors in transmission can be corrected, and original data sent from a transmitter can be recovered from received data. In optical communication scenarios, there are short-distance scenarios such as artificial intelligence (artificial intelligence, AI) and high performance computing (high performance computing, HPC), and there are also long-distance scenarios. Different scenarios have different delay requirements. A current inner-code processing solution of optical communication cannot be applied to a plurality of application scenarios.

### SUMMARY

Embodiments of this application provide a data transmission method, an apparatus, and a system, to provide an inner-code processing solution applicable to a plurality of application scenarios.

According to a first aspect, an embodiment of this application provides a data transmission method, applied to a first optical communication apparatus. The first optical communication apparatus may be a first optical module, or may be a first optical communication apparatus including a first optical module and a first host. The first optical module obtains outer-encoded first data, where the first data is any data in a to-be-sent data stream; and performs transmitter inner-code processing on the first data in a first inner-code processing mode, to obtain first encoded data, and outputs the first encoded data, where the first encoded data carries a first mode indication indicating the first inner-code processing mode, and the transmitter inner-code processing corresponding to the first inner-code processing mode includes at least inner encoding and pad processing. The first inner-code processing mode is one of a plurality of configured inner-code processing modes, and different inner-code processing modes in the plurality of inner-code processing modes have different processing manners.

Different inner-code processing modes have different processing manners, or different inner-code processing modes have different processing delays or performance (error correction capabilities), or different inner-code processing modes include different operation types or different operation parameters of a same operation. For example, several inner-code processing modes in the plurality of inner-code processing modes all include inner encoding, and that the several inner-code processing modes are different may be that operation types included in the several inner-code processing modes other than the inner encoding are different, or operation types included in the plurality of inner-code processing modes other than the inner encoding are different, or operation parameters of a same operation are different.

**In** a possible implementation, before the transmitter inner-code processing is performed on the first data in the first inner-code processing mode, the first inner-code processing mode may be first determined.

In this embodiment of this application, the plurality of inner-code processing modes are configured. The first optical module may select one inner-code processing mode from the plurality of inner-code processing modes based on a requirement, for example, different scenarios, and indicate the inner-code processing mode to a receiver by using data generated in an inner-code processing process. Therefore, the solutions according to embodiments of this application may be applied to a plurality of application scenarios.

In a possible implementation, the first mode indication is carried in a pad sequence of the first encoded data. The mode indication is added to the pad sequence, without occupying an additional resource and without changing a transmission baud rate.

In a possible implementation, that the pad sequence of the first encoded data carries N first mode indications may also be understood as that the pad sequence of the first encoded data carries N copies of the first mode indication, where N is an integer greater than 1. It may also be understood as that the first mode indication is repeatedly padded to the pad sequence of the first encoded data for N times. A plurality of copies are added, so that decoding accuracy and efficiency can be improved.

In a possible implementation, in the plurality of inner-code processing modes, there are at least two inner-code processing modes that satisfy at least one of the following:
convolutional interleaving depths in the two inner-code processing modes are different;
only one of the two inner-code processing modes includes convolutional interleaving;
one of the two inner-code processing modes includes circular shift, and the other inner-code processing mode does not include the circular shift; or
one of the two inner-code processing modes indicates to perform first inner-code processing, and the other inner-code processing mode indicates to skip the first inner-code processing, where the first inner-code processing includes at least inner encoding and pad processing, and the first inner-code processing mode is not the inner-code processing mode that indicates to skip the first inner-code processing.

In an example, the plurality of inner-code processing modes include at least two of a full-encoding and interleaving mode, a semi-encoding and interleaving mode, a convolutional interleaving transparent mode, a circular shift transparent mode, an inner-code skipping mode, and the like.

In a possible implementation, the transmitter inner-code processing corresponding to the first inner-code processing mode includes at least the pad processing and channel interleaving, and the pad processing includes addition of the first mode indication, where the pad processing is after the channel interleaving; or the pad processing is before the channel interleaving, where the first data includes data of a plurality of lanes; and when the pad processing is performed on the data of the plurality of lanes before the channel interleaving, the first mode indication is added to data of each lane in the data of the plurality of lanes.

It should be noted that, if the pad processing is after the channel interleaving, and the data of the plurality of lanes is included after the channel interleaving, the first mode indication may be added on each lane.

In this embodiment of this application, a second optical communication apparatus on a receive side may further determine the selected inner encoding mode. For example, the second optical communication apparatus on the receive side detects quality of a communication link.

In a possible implementation, the method further includes: receiving second encoded data from the second optical communication apparatus, where the second encoded data carries a second mode indication, the second mode indication indicates a second inner-code processing mode selected by the second optical communication apparatus, and the link is a link for communication between the first optical communication apparatus and the second optical communication apparatus; and performing, in the second inner-code processing mode, transmitter inner-code processing on outer-encoded third data in the data stream. For example, the second optical communication apparatus may select the inner-code processing mode based on the quality of the link. The second inner-code processing mode matches the quality that is of the link and that is detected by the second optical communication apparatus. Adaptation of the used inner-code processing mode can be improved. In some scenarios, in a scenario in which a transmitter cannot select an appropriate inner-code processing mode, the receiver may select the appropriate inner-code processing mode. This increases a scenario to which this application can be applied.

In a possible implementation, the method further includes: after receiving the second encoded data from the second optical communication apparatus, performing receiver inner-code processing on the second encoded data in the second inner-code processing mode, to obtain second data.

In a possible implementation, the method further includes:
after receiving the second encoded data from the second optical communication apparatus, performing receiver inner-code processing on the second encoded data in the inner-code processing mode indicated by the first mode indication, to obtain second data. For example, the second encoded data carries a first indication, and the first indication includes the first mode indication indicating the inner-code processing mode used before switching and the second mode indication indicating the inner-code processing mode used after the switching.

In another possible implementation, the method further includes:
receiving second encoded data from the second optical communication apparatus, where the second encoded data carries a second indication, and the second indication carries the first mode indication and a switching indication; and when the switching indication is of a first value, it indicates that the first inner-code processing mode matches quality that is of a link and that is detected by the second optical communication apparatus; or when the switching indication is of a second value, it indicates that the first inner-code processing mode does not match quality that is of a link and that is detected by the second optical communication apparatus, where the link is a link for communication between the first optical communication apparatus and the second optical communication apparatus; and
performing, in a third inner-code processing mode based on the switching indication, transmitter inner-code processing on outer-encoded third data in the data stream, where
when the switching indication is of the first value, the third inner-code processing mode is the first inner-code processing mode; or when the switching indication is of the second value, the third inner-code processing mode is an inner-code processing mode other than the first inner-code processing mode in the plurality of inner-code processing modes.

In the foregoing manner, the receiver notifies only whether the inner-code processing mode currently indicated by the transmitter adapts to a current link environment. Bit occupation can be reduced.

In still another possible implementation, the method further includes:
receiving second encoded data from the second optical communication apparatus, where the second encoded data carries a second indication, and the second mode indication carries the first mode indication and a switching indication; and when the switching indication is of a first value, it indicates that the first inner-code processing mode matches quality that is of a link and that is detected by the second optical communication apparatus; when the switching indication is of a second value, it indicates to switch to an inner-code processing mode whose delay or performance (error correction capability) is greater than that of the first inner-code processing mode; or when the switching indication is of a third value, it indicates to switch to an inner-code processing mode whose delay or performance (error correction capability) is less than that of the first inner-code processing mode, where the link is a link for communication between the first optical communication apparatus and the second optical communication apparatus; and
performing, in a third inner-code processing mode based on the switching indication, transmitter inner-code processing on outer-encoded third data in the data stream, where when the switching indication is of the first value, the third inner-code processing mode is the same as the first inner-code processing mode; when the switching indication is of the second value, a delay or performance (an error correction capability) of the third inner-code processing mode is greater than a delay or performance (an error correction capability) of the first inner-code processing mode; or when the switching indication is of the third value, a delay or performance (an error correction capability) of the third inner-code processing mode is less than a delay or performance (an error correction capability) of the first inner-code processing mode.

In the foregoing manner, the receiver notifies only whether the inner-code processing mode currently indicated by the transmitter adapts to a current link environment and a switching direction. In some scenarios, when a plurality of inner-code processing modes are all applicable to a current link environment, selectability of the plurality of inner-code processing modes may be provided for the transmitter.

In still another possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode; and
the method further includes:
receiving second encoded data from the second optical communication apparatus, where the second encoded data carries a fourth indication, where
when the inner-code processing mode indicated by the third mode indication matches quality that is of a link and that is detected by the second optical communication apparatus, the fourth indication includes the first mode indication and the third mode indication, and transmitter inner-code processing is performed, in the inner-code processing mode indicated by the third mode indication, on outer-encoded third data in the data stream; or
when the inner-code processing mode indicated by the third mode indication does not match quality that is of a link and that is detected by the second optical communication apparatus, the fourth indication includes the first mode indication and a fourth mode indication, where an inner-code processing mode indicated by the fourth mode indication matches the quality that is of the link and that is detected by the second optical communication apparatus; and transmitter inner-code processing is performed on outer-encoded third data in the inner-code processing mode indicated by the fourth mode indication.

In the foregoing solution, a mode in which inner-code processing is not skipped is first used to negotiate the inner-code processing mode, in other words, the transmitter and the receiver use the first mode indication in the negotiation process. The to-be-negotiated inner-code processing mode is applicable to a scenario in which the inner-code processing is skipped, and is also applicable to a scenario in which the inner-code processing is not skipped, so that an applicable scenario is added. In some scenarios, the inner-code processing mode used in the negotiation process may be the same as or certainly may be different from the to-be-negotiated inner-code processing mode. This is set based on a requirement. This is not specifically limited in embodiments of this application.

In still another possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode. The third mode indication may be an inner-code processing mode to be used (or in the future).

In a possible implementation, the method further includes:
receiving second data from the second optical communication apparatus, where the second data carries a fourth indication, and the fourth indication includes the first mode indication and a determining indication; and when the determining indication is of a first value, it indicates that the inner-code processing mode indicated by the third mode indication matches quality that is of a link and that is detected by the second optical communication apparatus; or when the determining indication is of a second value, it indicates that the inner-code processing mode indicated by the third mode indication does not match quality that is of a link and that is detected by the second optical communication apparatus, where the link is a link for communication between the first optical communication apparatus and the second optical communication apparatus; and
performing transmitter inner-code processing on third data in a third inner-code processing mode based on the determining indication, where
when the determining indication is of the first value, the third inner-code processing mode is the inner-code processing mode indicated by the third mode indication; or when the determining indication is of the second value, the third inner-code processing mode is an inner-code processing mode other than the third inner-code processing mode in the plurality of inner-code processing modes.

In a possible implementation, the first encoded data further carries a decoding indication indicating a decoding manner used in the first inner-code processing mode, and the decoding manner is hard decoding or soft decoding.

In some possible scenarios, both the first optical communication apparatus and the second optical communication apparatus are optical modules.

In some other possible scenarios, when the first optical communication apparatus includes the first host and the first optical module, the first host is configured to perform outer encoding, and the first optical module is configured to perform inner-code processing. The method further includes: The first host obtains fourth data from the to-be-sent data stream; the first host performs outer encoding on the fourth data to obtain outer-encoded fourth data, and sends the outer-encoded fourth data to the first optical module; and the first optical module skips the transmitter inner-code processing on the outer-encoded fourth data, and outputs the outer-encoded fourth data. When the transmitter inner-code processing is skipped on a transmit side, the first host may indicate the first optical module to skip the transmitter inner-code processing.

In a possible implementation, the outer-encoded fourth data previously obtained by performing the outer encoding by the first host may carry a fourth mode indication indicating a fourth inner-code processing mode, and the fourth inner-code processing mode indicates the first optical module to skip the transmitter inner-code processing.

According to a second aspect, an embodiment of this application provides another data transmission method, applied to a second optical communication apparatus. The method includes:
receiving first encoded data from a first optical communication apparatus, where the first encoded data carries a first mode indication, a first inner-code processing mode indicated by the first mode indication is one of a plurality of configured inner-code processing modes, and different inner-code processing modes in the plurality of inner-code processing modes have different processing manners; and
performing receiver inner-code processing on the first encoded data in the first inner-code processing mode, to obtain first data.

In a possible implementation, the first mode indication is carried in a pad sequence of the first encoded data.

In a possible implementation, the pad sequence of the first encoded data carries N copies of the first mode indication.

In a possible implementation, in the plurality of inner-code processing modes, there are at least two inner-code processing modes that satisfy at least one of the following:
convolutional interleaving depths in the two inner-code processing modes are different;
only one of the two inner-code processing modes includes convolutional interleaving;
one of the two inner-code processing modes includes circular shift, and the other inner-code processing mode does not include the circular shift; or
one of the two inner-code processing modes indicates to perform first inner-code processing, and the other inner-code processing mode indicates to skip the first inner-code processing, where the first inner-code processing includes at least inner encoding and pad processing, and the first inner-code processing mode is not the inner-code processing mode that indicates to skip the first inner-code processing.

In a possible implementation, the receiver inner-code processing corresponding to the first inner-code processing mode includes at least de-pad processing and channel de-interleaving, and the de-pad processing includes detection of the first mode indication, where
the de-pad processing is before the channel de-interleaving; or
the de-pad processing is after the channel de-interleaving, where in a de-pad processing process, the first mode indication is detected in data of a plurality of lanes that is obtained through the channel de-interleaving.

In a possible implementation, the method further includes:
sending second encoded data to the first optical communication apparatus, where the second encoded data carries a second mode indication, a second inner-code processing mode indicated by the second mode indication matches quality that is of a link and that is detected by the second optical communication apparatus, and the link is a link for communication between the first optical communication apparatus and the second optical communication apparatus;
receiving third encoded data from the first optical communication apparatus; and
performing receiver inner-code processing on the third encoded data in the second inner-code processing mode.

In a possible implementation, the second encoded data carries a first indication, and the first indication includes the first mode indication indicating the inner-code processing mode used before switching and the second mode indication indicating the inner-code processing mode used after the switching.

In a possible implementation, the method further includes:
sending second encoded data to the first optical communication apparatus, where the second encoded data carries a second indication, and the second indication carries the first mode indication and a switching indication; and when the switching indication is of a first value, it indicates that the inner-code processing mode indicated by the first mode indication matches quality that is of a link and that is detected by the second optical communication apparatus; or when the switching indication is of a second value, it indicates that the first mode indication does not match quality that is of a link and that is detected by the second optical communication apparatus, where the link is a link for communication between the first optical communication apparatus and the second optical communication apparatus.

In a possible implementation, the method further includes:
receiving third encoded data from the first optical communication apparatus, where
when the switching indication is of the first value, the third encoded data carries the first mode indication, and receiver inner-code processing is performed on the third encoded data still in the first inner-code processing mode; or
when the switching indication is of the second value, the third encoded data carries a mode indication indicating a third inner-code processing mode, and receiver inner-code processing is performed on the third encoded data in the third inner-code processing mode, where the third inner-code processing mode is an inner-code processing mode other than the first inner-code processing mode in the plurality of inner-code processing modes.

In a possible implementation, the method further includes:
sending second encoded data to the first optical communication apparatus, where the second encoded data carries a second indication, and the second indication carries the first mode indication and a switching indication; and when the switching indication is of a first value, it indicates that the inner-code processing mode indicated by the first mode indication matches quality that is of a link and that is detected by the second optical communication apparatus; when the switching indication is of a third value, it indicates to switch to an inner-code processing mode whose delay or performance (error correction capability) is greater than that of the first inner-code processing mode; or when the switching indication is of a fourth value, it indicates to switch to an inner-code processing mode whose delay or performance (error correction capability) is less than that of the first inner-code processing mode, where the link is a link for communication between the first optical communication apparatus and the second optical communication apparatus.

In a possible implementation, the method further includes:
receiving third encoded data from the first optical communication apparatus; and
performing receiver inner-code processing on the third encoded data in a third inner-code processing mode based on the switching indication, where
when the switching indication is of the first value, the third inner-code processing mode is the same as the first inner-code processing mode; when the switching indication is of the third value, a delay or performance (an error correction capability) of the third inner-code processing mode is greater than a delay or performance (an error correction capability) of the first inner-code processing mode; or when the switching indication is of the fourth value, a delay or performance (an error correction capability) of the third inner-code processing mode is less than a delay or performance (an error correction capability) of the first inner-code processing mode.

In a possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode; and
sending second encoded data to the first optical communication apparatus, where the second encoded data carries a fourth indication, where
when the inner-code processing mode indicated by the third mode indication matches quality that is of a link and that is detected by the second optical communication apparatus, the fourth indication includes the first mode indication and the third mode indication; or
when the inner-code processing mode indicated by the third mode indication does not match quality that is of a link and that is detected by the second optical communication apparatus, the fourth indication includes the first mode indication and a fourth mode indication, where an inner-code processing mode indicated by the fourth mode indication matches the quality that is of the link and that is detected by the second optical communication apparatus.

In a possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode; and
the method further includes:
sending second encoded data to the first optical communication apparatus, where the second encoded data is obtained by performing transmitter inner-code processing in the first inner-code processing mode, the second encoded data carries a fourth indication, and the fourth indication includes the first mode indication and a determining indication; and when the determining indication is of a first value, it indicates that the third mode indication matches quality that is of a link and that is detected by the second optical communication apparatus; or when the determining indication is of a second value, it indicates that the third mode indication does not match quality that is of a link and that is detected by the second optical communication apparatus, where the link is a link for communication between the first optical communication apparatus and the second optical communication apparatus.

In a possible implementation, the method further includes:
detecting the quality of the link between the first optical communication apparatus and the second optical communication apparatus based on the first encoded data, where an inner-code processing mode that matches the quality of the link and that is in the plurality of inner-code processing modes satisfies at least one of the following:
in a process of performing inner decoding on the first encoded data, a determined first quantity of non-zero syndromes in syndromes of N1 consecutive codewords in the first encoded data is within a first quantity range corresponding to the matched inner-code processing mode in the plurality of inner-code processing modes, each of the plurality of inner-code processing modes corresponds to one first quantity range, and different inner-code processing modes correspond to different first quantity ranges, where N1 is an integer greater than 1;
in a process of performing inner decoding on the first encoded data, a determined first proportion of non-zero syndromes in syndromes of N2 consecutive codewords in the first encoded data is within a first proportion range corresponding to the matched inner-code processing mode, each of the plurality of inner-code processing modes corresponds to one first proportion range, and different inner-code processing modes correspond to different first proportion ranges, where N2 is an integer greater than 1;
in a process of performing inner decoding on N3 consecutive bits in the first encoded data, a determined quantity of corrected bits is within a second quantity range corresponding to the matched inner-code processing mode, each of the plurality of inner-code processing modes corresponds to one second quantity range, and different inner-code processing modes correspond to different second quantity ranges, where N3 is an integer greater than 1;
in a process of performing inner decoding on N4 consecutive bits in the first encoded data, a determined second proportion of a quantity of corrected bits to the N3 bits is within a second proportion range corresponding to the matched inner-code processing mode, each of the plurality of inner-code processing modes corresponds to one second proportion range, and different inner-code processing modes correspond to different second proportion ranges, where N4 is an integer greater than 1;
in a process of performing inner decoding on N5 consecutive codewords of the first encoded data, a determined third quantity of error correction-failed codewords is within a third quantity range corresponding to the matched inner-code processing mode, each of the plurality of inner-code processing modes corresponds to one third quantity range, and different inner-code processing modes correspond to different third quantity ranges, where N5 is an integer greater than 1;
in a process of performing inner decoding on N6 consecutive codewords of the first encoded data, a determined third proportion of error correction-failed codewords is within a third proportion range corresponding to the matched inner-code processing mode, each of the plurality of inner-code processing modes corresponds to one third proportion range, and different inner-code processing modes correspond to different third proportion ranges, where N6 is an integer greater than 1;
in a process of performing inner decoding and outer decoding on N7 consecutive codewords of the first encoded data, a determined fourth quantity of error correction-failed codewords is within a fourth quantity range corresponding to the matched inner-code processing mode, each of the plurality of inner-code processing modes corresponds to one fourth quantity range, and different inner-code processing modes correspond to different fourth quantity ranges, where N7 is an integer greater than 1; or
in a process of performing inner decoding and outer decoding on N8 consecutive codewords of the first encoded data, a determined fourth proportion of error correction-failed codewords is within a fourth proportion range corresponding to the matched inner-code processing mode, each of the plurality of inner-code processing modes corresponds to one fourth proportion range, and different inner-code processing modes correspond to different fourth proportion ranges, where N8 is an integer greater than 1.

In a possible implementation, the first encoded data further carries a decoding indication indicating a decoding manner used in the first inner-code processing mode, and the decoding manner is hard decoding or soft decoding; and
the receiver inner-code processing includes inner decoding, and the inner decoding uses the decoding manner indicated by the decoding indication.

In a possible implementation, both the first optical communication apparatus and the second optical communication apparatus are optical modules.

In a possible implementation, the method further includes:
receiving fourth data from the second optical communication apparatus, and detecting a rate of the fourth data; and
when it is determined, based on the rate of the fourth data, that a used inner-code processing mode indicates to skip receiver inner-code processing, skipping the receiver inner-code processing on the fourth data.

According to a third aspect, an embodiment of this application provides a data transmission method, applied to a first optical communication apparatus. The first optical communication apparatus includes a first host and a first optical module, and the method includes:

The first host obtains first data, where the first data is any data in a to-be-sent data stream;
the first host performs outer encoding on the first data to obtain outer-encoded first data, where the outer-encoded first data carries a first mode indication, the first mode indication indicates a first inner-code processing mode used for communication between a second optical communication apparatus and the first optical communication apparatus, the first inner-code processing mode is one of a plurality of configured inner-code processing modes, and different inner-code processing modes in the plurality of inner-code processing modes have different processing delays or performance (error correction capabilities); and
the first optical module performs, in a second inner-code processing mode, transmitter inner-code processing on the outer-encoded first data, to obtain first encoded data, and outputs the first encoded data to the second optical communication apparatus, where the second inner-code processing mode is a default inner-code processing mode in the plurality of inner-code processing modes.

In the foregoing solution, the host indicates the used inner-code processing mode. The optical module first performs inner-code processing in the default inner-code processing mode. The inner-code processing mode indicated by the host may be skipping the inner-code processing, or may be not skipping the inner-code processing. If the inner-code processing is not skipped, the inner-code processing mode indicated by the host includes at least inner encoding and PAD insertion.

In a possible implementation, the second inner-code processing mode includes at least inner encoding and pad processing. In another possible implementation, the second inner-code processing mode may alternatively be skipping the inner-code processing.

In a possible implementation, the first mode indication is carried in a pad sequence of the outer-encoded first data.

In a possible implementation, the pad sequence of the outer-encoded first data carries N copies of the first mode indication, where N is an integer greater than 1.

In a possible implementation, in the plurality of inner-code processing modes, there are at least two inner-code processing modes that satisfy at least one of the following:
convolutional interleaving depths in the two inner-code processing modes are different;
only one of the two inner-code processing modes includes convolutional interleaving;
one of the two inner-code processing modes includes circular shift, and the other inner-code processing mode does not include the circular shift; or
one of the two inner-code processing modes indicates to perform first inner-code processing, and the other inner-code processing mode indicates to skip the first inner-code processing, where the first inner-code processing includes at least inner encoding and pad processing, and the first inner-code processing mode is not the inner-code processing mode that indicates to skip the first inner-code processing.

In a possible implementation, the method further includes:

The first optical module receives second encoded data from the second optical communication apparatus;
the first optical module performs receiver inner-code processing on the second encoded data in the first inner-code processing mode, to obtain outer-encoded second data, where the outer-encoded second data carries a second mode indication, and an inner-code processing mode indicated by the second mode indication is different from the first inner-code processing mode; and
the first host performs outer decoding processing on the outer-encoded second data, to obtain decoded second data.

In the foregoing solution, if the first inner-code processing mode is skipping the inner-code processing, that the first optical module performs the receiver inner-code processing on the second encoded data in the first inner-code processing mode, to obtain the outer-encoded second data may be that the first optical module skips the inner-code processing on the second encoded data through the first inner-code processing mode.

In a possible implementation, the method further includes:

The first optical module performs, in the inner-code processing mode indicated by the second mode indication, transmitter inner-code processing on outer-encoded third data in the data stream, to obtain third encoded data, and sends the third encoded data.

In a possible implementation, the outer-encoded second data carries a first indication, and the first indication includes the first mode indication and the second mode indication.

In a possible implementation, the method further includes:

The first optical module receives second encoded data from the second optical communication apparatus;
the first optical module performs receiver inner-code processing on the second encoded data in the first inner-code processing mode, to obtain outer-encoded second data, where the outer-encoded second data carries the first mode indication; and
the first host performs outer decoding processing on the outer-encoded second data, to obtain decoded second data.

In a possible implementation, the outer-encoded second data carries a second indication, and the second indication includes the first mode indication and a switching indication; and when the switching indication is of a first value, it indicates that the first inner-code processing mode matches quality that is of a link and that is detected by the second optical communication apparatus; or when the switching indication is of a second value, it indicates that the first inner-code processing mode does not match quality that is of a link and that is detected by the second optical communication apparatus, where the link is a link for communication between the first optical communication apparatus and the second optical communication apparatus.

The method further includes:
The first optical module performs, in a third inner-code processing mode, transmitter inner-code processing on outer-encoded third data in the data stream, to obtain third encoded data, and sends the third encoded data, where
when the switching indication is of the first value, the third inner-code processing mode is the same as the first inner-code processing mode; or when the switching indication is of the second value, the third inner-code processing mode is an inner-code processing mode other than the first inner-code processing mode in the plurality of inner-code processing modes.

In a possible implementation, the outer-encoded second data carries a third indication, and the third indication includes the first mode indication and a switching indication; and when the switching indication is of a first value, it indicates that the first inner-code processing mode matches quality that is of a link and that is detected by the second optical communication apparatus; when the switching indication is of a third value, it indicates to switch to an inner-code processing mode whose delay or performance (error correction capability) is greater than that of the first inner-code processing mode; or when the switching indication is of a fourth value, it indicates to switch to an inner-code processing mode whose delay or performance (error correction capability) is less than that of the first inner-code processing mode, where the link is a link for communication between the first optical communication apparatus and the second optical communication apparatus.

The method further includes:
The first optical module performs, in a third inner-code processing mode based on the switching indication, transmitter inner-code processing on outer-encoded third data in the data stream, to obtain third encoded data, and sends the third encoded data, where
when the switching indication is of the first value, the third inner-code processing mode is the same as the first inner-code processing mode;
when the switching indication is of the third value, a delay or performance (an error correction capability) of the third inner-code processing mode is greater than a delay or performance (an error correction capability) of the first inner-code processing mode; or
when the switching indication is of the fourth value, a delay or performance (an error correction capability) of the third inner-code processing mode is less than a delay or performance (an error correction capability) of the first inner-code processing mode.

According to a fourth aspect, an embodiment of this application provides a data transmission method, applied to a second optical communication apparatus, where the second optical communication apparatus includes a second host and a second optical module, and the method includes: The second optical module receives first encoded data from a first optical communication apparatus; the second optical module performs receiver inner-code processing on the first encoded data in a second inner-code processing mode, to obtain outer-encoded first data, where the second inner-code processing mode is a default inner-code processing mode in a plurality of inner-code processing modes, the second inner-code processing mode includes at least inner encoding and pad processing, and different inner-code processing modes in the plurality of inner-code processing modes have different processing manners; and the second host performs receiver outer decoding on the outer-encoded first data, where the outer-encoded first data carries a first mode indication, the first mode indication indicates a first inner-code processing mode used by the second optical module, and the first inner-code processing mode is one of the plurality of configured inner-code processing modes.

In a possible implementation, the first mode indication is carried in a pad sequence of the outer-encoded first data.

In a possible implementation, the pad sequence of the outer-encoded first data carries N copies of the first mode indication, where N is an integer greater than 1.

In a possible implementation, in the plurality of inner-code processing modes, there are at least two inner-code processing modes that satisfy at least one of the following:
convolutional interleaving depths in the two inner-code processing modes are different;
only one of the two inner-code processing modes includes convolutional interleaving;
one of the two inner-code processing modes includes circular shift, and the other inner-code processing mode does not include the circular shift; or
one of the two inner-code processing modes indicates to perform first inner-code processing, and the other inner-code processing mode indicates to skip the first inner-code processing, where the first inner-code processing includes at least inner encoding and pad processing, and the first inner-code processing mode is not the inner-code processing mode that indicates to skip the first inner-code processing.

In a possible implementation, the method further includes:
The second host performs outer encoding processing on second data in a data stream, to obtain outer-encoded second data, where the outer-encoded second data carries a second mode indication, an inner-code processing mode indicated by the second mode indication matches quality that is of a link and that is detected by the second host, and the link is a link for communication between the first optical communication apparatus and the second optical communication apparatus, where
the inner-code processing mode indicated by the second mode indication is different from the first inner-code processing mode;
the second optical module performs, in the first inner-code processing mode, transmitter inner-code processing on the outer-encoded second data, to obtain second encoded data; and
the second optical module sends the second encoded data to the first optical communication apparatus.

In a possible implementation, the method further includes:
The second optical module receives third encoded data from the first optical communication apparatus; and
the second optical module performs receiver inner-code processing on the third encoded data in the inner-code processing mode indicated by the second mode indication.

In a possible implementation, the outer-encoded second data carries a first indication, and the first indication includes the first mode indication and the second mode indication.

In a possible implementation, the method further includes:
the second host performs outer encoding on second data in a data stream, to obtain outer-encoded second data, where the outer-encoded second data carries the first mode indication; and
the second optical module performs transmitter inner-code processing on the out-encoded second data in the first inner-code processing mode, to obtain second encoded data, and sends the second encoded data to the second optical communication device.

In a possible implementation, the outer-encoded second data carries a second indication, and the second indication includes the first mode indication and a switching indication; and when the switching indication is of a first value, it indicates that the first inner-code processing mode matches quality that is of a link and that is detected by the second optical communication apparatus; or when the switching indication is of a second value, it indicates that the first inner-code processing mode does not match quality that is of a link and that is detected by the second optical communication apparatus, where the link is a link for communication between the first optical communication apparatus and the second optical communication apparatus.

The method further includes:
After sending the second encoded data, the second optical module receives third encoded data, and performs receiver inner-code processing on the third encoded data in a third inner-code processing mode, where
when the switching indication is of the first value, the third inner-code processing mode is the same as the first inner-code processing mode; or when the switching indication is of the second value, the third inner-code processing mode is an inner-code processing mode other than the first inner-code processing mode in the plurality of inner-code processing modes.

In a possible implementation, the outer-encoded second data carries a third indication, and the third indication includes the first mode indication and a switching indication; and when the switching indication is of a first value, it indicates that the first inner-code processing mode matches quality that is of a link and that is detected by the second optical communication apparatus; when the switching indication is of a third value, it indicates to switch to an inner-code processing mode whose delay or performance (error correction capability) is greater than that of the first inner-code processing mode; or when the switching indication is of a fourth value, it indicates to switch to an inner-code processing mode whose delay or performance (error correction capability) is less than that of the first inner-code processing mode, where the link is a link for communication between the first optical communication apparatus and the second optical communication apparatus.

The method further includes:
After sending the second encoded data, the second optical module receives third encoded data, and performs, in a third inner-code processing mode based on the switching indication, transmitter inner-code processing on the third encoded data in the data stream, where
when the switching indication is of the first value, the third inner-code processing mode is the same as the first inner-code processing mode;
when the switching indication is of the third value, a delay or performance (an error correction capability) of the third inner-code processing mode is greater than a delay or performance (an error correction capability) of the first inner-code processing mode; or
when the switching indication is of the fourth value, a delay or performance (an error correction capability) of the third inner-code processing mode is less than a delay or performance (an error correction capability) of the first inner-code processing mode.

In a possible implementation, the method further includes:
detecting the quality of the link between the first optical communication apparatus and the second optical communication apparatus based on the first encoded data, where an inner-code processing mode that matches the quality of the link and that is in the plurality of inner-code processing modes satisfies at least one of the following:
in a process of performing outer decoding on M1 consecutive code blocks of the first encoded data, a determined quantity of error correction-failed code blocks is within a quantity range corresponding to the matched inner-code processing mode, each of the plurality of inner-code processing modes corresponds to one quantity range, and different inner-code processing modes correspond to different quantity ranges, where M1 is an integer greater than 1; or
in a process of performing inner decoding and outer decoding on M2 consecutive code blocks of the first encoded data, a determined proportion of error correction-failed code blocks is within a proportion range corresponding to the matched inner-code processing mode, each of the plurality of inner-code processing modes corresponds to one proportion range, and different inner-code processing modes correspond to different proportion ranges, where M2 is an integer greater than 1.

According to a fifth aspect, an embodiment of this application provides an optical module, including a communication unit and an inner-code processing unit, where the communication unit is configured to send and receive data, and the inner-code processing unit is configured to perform the method performed by the optical module in any one of the first aspect or the implementations of the first aspect.

According to a sixth aspect, an embodiment of this application provides an optical module, including a communication unit and an inner-code processing unit, where the communication unit is configured to send and receive data, and the inner-code processing unit is configured to perform the method performed by the optical module in any one of the second aspect or the implementations of the second aspect.

According to a seventh aspect, an embodiment of this application provides an optical communication apparatus, including a memory and a processor. The memory stores program instructions, and the processor runs the program instructions to perform the method provided in any one of the first aspect, the second aspect, and the possible implementations thereof of this application.

According to an eighth aspect, this application provides a computer-readable storage medium, including program instructions. When the program instructions are run on a computer device, the computer device is caused to perform the method provided in any one of the first aspect, the second aspect, and the possible implementations thereof of this application.

According to a ninth aspect, this application provides a computer program product. When the computer program product runs on a computer, the computer is caused to perform the method provided in any one of the first aspect, the second aspect, and the possible implementations thereof of this application.

In this application, based on the implementations provided in the foregoing aspects, the implementations may be further combined to provide more implementations.

### BRIEF DESCRIPTION OF DRAWINGS

FIG. 1 is a diagram of a structure of an optical communication system according to an embodiment of this application;
FIG. 2A is a diagram of an inner-code processing procedure of a transmitter and a receiver according to an embodiment of this application;
FIG. 2B is diagram of another inner-code processing procedure of a transmitter and a receiver according to an embodiment of this application;
FIG. 3 is a schematic flowchart of a data transmission method provided in Example 1 according to an embodiment of this application;
FIG. 4 is a diagram of a frame structure according to an embodiment of this application;
FIG. 5A is a diagram of a mode indication insertion procedure according to an embodiment of this application;
FIG. 5B is a diagram of another mode indication insertion procedure according to an embodiment of this application;
FIG. 6A is a schematic flowchart of a data transmission method provided in Example 2 according to an embodiment of this application;
FIG. 6B is a schematic flowchart of another data transmission method provided in Example 2 according to an embodiment of this application;
FIG. 6C is a schematic flowchart of still another data transmission method provided in Example 2 according to an embodiment of this application;
FIG. 7 is a schematic flowchart of a data transmission method provided in Example 3 according to an embodiment of this application;
FIG. 8 is a diagram of a structure of a second indication provided in Example 3 according to an embodiment of this application;
FIG. 9A is a schematic flowchart of a data transmission method provided in Example 4 according to an embodiment of this application;
FIG. 9B is a schematic flowchart of another data transmission method provided in Example 4 according to an embodiment of this application;
FIG. 10 is a schematic flowchart of a data transmission method provided in Example 5 according to an embodiment of this application;
FIG. 11 is a schematic flowchart of a data transmission method provided in Example 6 according to an embodiment of this application;
FIG. 12 is a schematic flowchart of a data transmission method provided in Example 7 according to an embodiment of this application;
FIG. 13 is a diagram of a structure of an optical module according to an embodiment of this application;
FIG. 14 is a diagram of another structure of an optical module according to an embodiment of this application; and
FIG. 15 is a diagram of a structure of an optical communication apparatus according to an embodiment of this application.

### DESCRIPTION OF EMBODIMENTS

The following describes the technical solutions in embodiments of this application with reference to the accompanying drawings in embodiments of this application.

In the descriptions of this application, unless otherwise specified, "a plurality of" means two or more. In addition, "/" represents an "or" relationship between associated objects. For example, A/B may represent A or B. The term "and/or" in this application is merely an association relationship for describing associated objects, and represents that three relationships may exist. For example, A and/or B may represent the following three cases: Only A exists, both A and B exist, and only B exists, where A and B each may be singular or plural. In addition, in embodiments of this application, terms such as "first" and "second" are used to distinguish between same objects or similar objects whose functions and purposes are basically the same, to clearly describe the technical solutions in embodiments of this application. A person skilled in the art may understand that the terms such as "first" and "second" do not limit a quantity or an execution sequence, and the terms such as "first" and "second" do not indicate a definite difference. It should be further noted that, unless otherwise specified, specific descriptions of some technical features in one embodiment may also be applied to explain corresponding technical features mentioned in another embodiment. In embodiments of this application, "data" may also be referred to as a "signal".

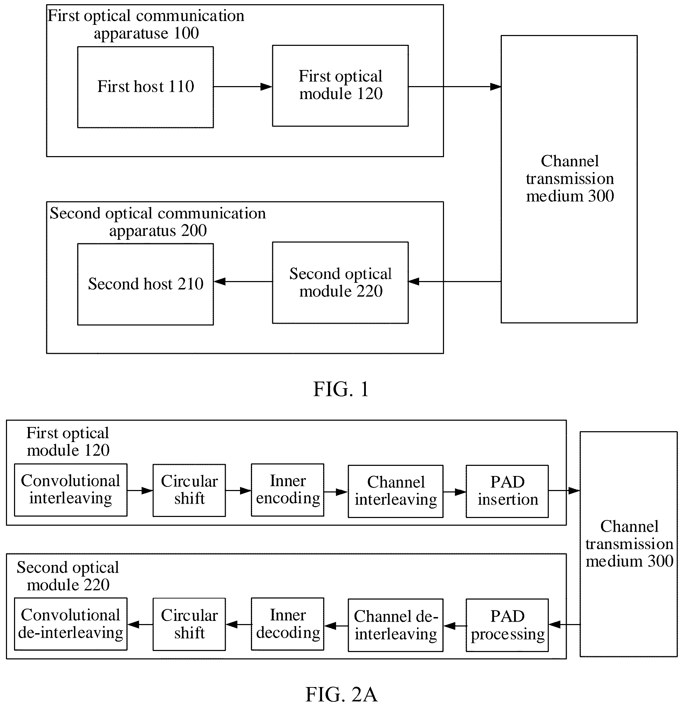

Before embodiments of this application are described in detail in this specification, an optical communication system to which embodiments of this application are applied is first described. FIG. 1 is a diagram of a structure of an optical communication system. The optical communication system includes a plurality of optical communication devices. In FIG. 1, two optical communication devices are used as an example, and are respectively a first optical communication apparatus 100 and a second optical communication device 200. The optical communication system may further include a channel transmission medium 300. For example, the channel transmission medium 300 may be an optical fiber. In some embodiments, the first optical communication apparatus 100 and the second optical communication device 200 may be a transmitter and a receiver of each other. The first optical communication apparatus 100 includes a first host (host) 110 and a first optical module 120. The second optical communication device 200 includes a second host 210 and a second optical module 220. The first host 110 may also be referred to as a first client-side chip (host chip), and the second host 210 may be referred to as a second client-side chip (host chip). The first host 110 and the first optical module 120 may be connected through an attachment unit interface (attachment unit interface, AUI). The second host 210 and the second optical module 220 may be connected through an AUI. The AUI may also be referred to as an additional unit interface. The first host (host) 110, the first optical module 120, the channel transmission medium 300, the second host 210, and the second optical module 220 all may support bidirectional transmission, or may support unidirectional transmission. This is not specifically limited in embodiments of this application.

After undergoing transmitter outer-code processing (including at least transmitter outer encoding) on the first host 110, a to-be-sent data stream on the first host 110 may be sent to the first optical module 120 through an attachment unit interface (attachment unit interface, AUI)/additional unit interface lane. The first optical module 120 processes the outer-encoded data stream, where the processing performed by the first optical module 120 includes at least transmitter inner-code processing. The first optical module 120 may send a processed encoded data stream to the second optical communication device 200 through the channel transmission medium 300. After receiving the encoded data stream, the second optical communication device 200 performs inverse processing by using the second optical module 220, where the inverse processing includes at least receiver inner-code processing. Then, a data stream obtained through the inverse processing is sent to the second host 210 through an AUI lane. The second host 210 performs receiver outer-code processing (including at least receiver outer decoding) on the received data stream, to complete a transmission procedure of the data stream.

"Inner" in inner code and "outer" in outer code indicate distances between execution bodies that perform operations on data and the channel transmission medium 300. An execution body that performs an operation on the inner code is closer to the channel transmission medium, and an execution body that performs an operation on the outer code is farther away from the channel transmission medium. In this embodiment of this application, data is transmitted from the first host 110 to the channel transmission medium 300 through the first optical module 120, and then is transmitted from the channel transmission medium 300 to the second host 210 through the second optical module 220. Data processed by the first host 110 is farther away from the channel transmission medium 300 than data processed by the first optical module 120, and data processed by the second host 210 is farther away from the channel transmission medium 300 than data processed by the second optical module 220. Therefore, the data processed by the first host 110 is referred to as data on which outer-code processing is performed, the data processed by the first optical module 120 is referred to as data on which inner-code processing is performed, the data processed by the second host 210 is referred to as data on which outer-code processing is performed, and the data processed by the second optical module 220 is referred to as data on which inner-code processing is performed.

Optical communication scenarios may include scenarios such as a data center, cloud storage, cloud computing, and backbone network transmission of a 5G base station. In the optical communication scenarios, there are short-distance scenarios such as artificial intelligence (artificial intelligence, AI) and high performance computing (high performance computing, HPC), and there are also long-distance scenarios. Different scenarios have different delay requirements. Some scenarios have strict delay requirements, and some scenarios allow a specific delay. Therefore, a current encoding processing solution cannot adapt to a plurality of application scenarios.

In view of this, embodiments of this application provide a signal transmission method, an apparatus, and a system, to provide a solution to adapt to various application scenarios. Embodiments of this application provide an inner-code processing selection solution in which a plurality of inner-code processing modes are configured, so that an appropriate inner-code processing mode can be selected based on a requirement. Embodiments of this application provide a plurality of inner-code processing modes. Different inner-code processing modes in the plurality of inner-code processing modes have different processing delays or performance (error correction capabilities).

For example, transmitter inner-code processing may include a plurality of operations, and may include one or more of convolutional interleaving, circular shift, inner encoding, channel interleaving, pad (PAD) insertion, and the like. Receiver inner-code processing may include a plurality of operations corresponding to the transmitter inner-code processing, and may include PAD processing, channel de-interleaving, inner decoding (or inner de-coding), circular shift, and convolutional de-interleaving.

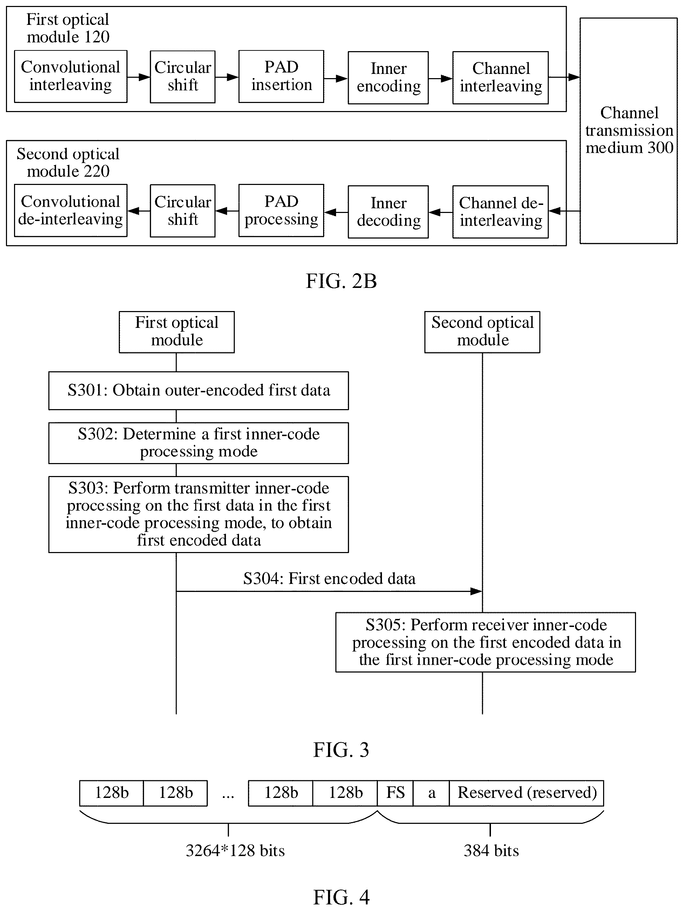

FIG. 2A and FIG. 2B each are a diagram of an inner-code processing procedure of a transmitter and a receiver according to an embodiment of this application. A difference between FIG. 2A and FIG. 2B lies in that PAD insertion (PAD processing) is performed at different positions in inner-code processing procedures.

Refer to FIG. 2A. When performing transmitter inner-code processing, the first optical module 120 sequentially performs operations such as convolutional interleaving, circular shift, inner encoding, channel interleaving, and periodic PAD sequence insertion on received outer-encoded data. Correspondingly, when performing receiver inner-code processing, the second optical module 220 sequentially performs operations of PAD processing, channel de-interleaving, inner decoding, circular shift, and convolutional de-interleaving. The PAD insertion operation may alternatively be performed before the inner encoding and the channel interleaving, as shown in FIG. 2B. When performing transmitter inner-code processing, the first optical module 120 sequentially performs operations such as convolutional interleaving, circular shift, periodic PAD sequence insertion, inner encoding, and channel interleaving on received outer-encoded data. Correspondingly, when performing receiver inner-code processing, the second optical module 220 sequentially performs operations of channel de-interleaving, inner decoding, PAD processing, circular shift, and convolutional de-interleaving.

Usually, when the first optical module 120 performs transmitter inner-code processing, or the second optical module performs receiver inner-code processing, a delay of dozens of nanoseconds to hundreds of nanoseconds (ns) may be caused. In a delay-sensitive scenario, the inner-code processing procedure shown in FIG. 2A or FIG. 2B may not satisfy a requirement. In embodiments of this application, some operations may be disabled/transparently transmitted. For example, a convolutional interleaving operation is disabled/transparently transmitted. Alternatively, an interleaving depth of a convolutional interleaving operation is reduced, to reduce a delay. In view of this, a plurality of inner-code processing modes may be configured in embodiments of this application. Different inner-code processing modes have different processing manners, or different inner-code processing modes have different processing delays or performance (for example, error correction capabilities), or different inner-code processing modes include different operation types or different operation parameters of a same operation. For example, several inner-code processing modes in the plurality of inner-code processing modes all include inner encoding, and that the several inner-code processing modes are different may be that operation types included in the several inner-code processing modes other than the inner encoding are different, or operation types included in the plurality of inner-code processing modes other than the inner encoding are different, or operation parameters of a same operation are different.

The following describes the plurality of inner-code processing modes by using examples. For example, in the plurality of inner-code processing modes, there are at least two inner-code processing modes that satisfy at least one of the following:
convolutional interleaving depths in the two inner-code processing modes are different; only one of the two inner-code processing modes includes convolutional interleaving; one of the two inner-code processing modes includes circular shift, and the other inner-code processing mode does not include the circular shift; or one of the two inner-code processing modes indicates to perform first inner-code processing, and the other inner-code processing mode indicates to skip the first inner-code processing, where the first inner-code processing includes at least inner encoding and pad processing, and the first inner-code processing mode is not the inner-code processing mode that indicates to skip the first inner-code processing.

In an example, the plurality of inner-code processing modes include at least two of a full-encoding and interleaving mode, a semi-encoding and interleaving mode, a convolutional interleaving transparent mode, a circular shift transparent mode, an inner-code skipping mode, and the like. The full-encoding and interleaving mode may be performed in each step included in transmitter/receiver inner-code processing, and a convolutional interleaving depth is a supported maximum convolutional interleaving depth (also briefly referred to as an interleaving depth). The semi-encoding and interleaving mode may be understood as being performed in each step included in the transmitter/receiver inner-code processing, but an interleaving depth is less than the interleaving depth used in the full-encoding and interleaving mode. For example, the interleaving depth of the semi-encoding and interleaving mode may be half of the interleaving depth of the full-encoding and interleaving mode. For example, the full-encoding and interleaving mode uses a 12-way KP4 interleaving manner. It should be noted that a KP4 codeword is RS (544, 514, 15, 10), to be specific, the KP4 codeword includes 544 symbols, where 514 symbols are information symbols. Errors of a maximum of 15 symbols can be corrected at one time of decoding, and each symbol includes 10 bits. An interleaving unit may process a received bit stream in a row-column interleaving manner, in other words, write bits by row and read the bits by column, to implement an interleaving function. This is an interleaving method that is easy to implement. Certainly, another interleaving method may be used. This is not limited in this application. The RS code indicates a Reed-Solomon (Reed-solomon) code. In some possible scenarios, a configured inner-code processing mode may include a plurality of semi-encoding and interleaving modes, and interleaving depths of different semi-encoding and interleaving modes are different.

The following describes a data transmission solution in embodiments of this application with reference to the accompanying drawings. Embodiments of this application provide, for example, a plurality of data transmission solutions.

In a first possible transmission manner, a transmitter selects an inner-code processing mode, and an optical module adds, to data in an inner-code processing process, a mode indication indicating the inner-code processing mode, to indicate the inner-code processing mode to a receiver. The indicated inner-code processing mode includes at least inner encoding and PAD insertion.

In a second possible transmission manner, after a transmitter selects an inner-code processing mode and indicates the inner-code processing mode to a receiver, the receiver may determine, based on detected channel quality, whether the inner-code processing mode selected by the transmitter matches the channel quality.

In a third possible transmission manner, an inner-code processing mode selected by a transmitter is skipping transmitter inner-code processing, and a host adds a mode indication to data in an outer-code processing process.

**In** a fourth possible transmission manner, a transmitter and a receiver negotiate a to-be-used inner-code processing mode in an outer-code processing process.

The following describes the foregoing four transmission manners with reference to the accompanying drawings. The following provides descriptions with reference to an optical module of a transmitter and an optical module of a receiver. The transmitter and the receiver described herein are relative. In some scenarios, a device of a transmitter may alternatively serve as a receiver, and a device of a receiver may alternatively serve as a transmitter. For example, the optical module of the transmitter may be the first optical module 120 in the first optical communication apparatus, and the optical module of the receiver may be the second optical module 220 in the second optical communication device. Alternatively, the optical module of the transmitter may be the second optical module 220 in the second optical communication device, and the optical module of the receiver may be the first optical module 120 in the first optical communication apparatus. An example in which the optical module of the transmitter may be the first optical module 120 in the first optical communication apparatus, and the optical module of the receiver may be the second optical module 220 in the second optical communication device is used below. Subsequently, for ease of description, a digital identifier of each unit is not described again.

The following describes the first possible transmission manner with reference to the accompanying drawings. Example 1 is applicable to a scenario in which a first optical communication apparatus and a second optical communication device are a transmitter and a receiver of each other, and is also applicable to a unidirectional transmission scenario, to be specific, a scenario in which the first optical communication apparatus serves as a transmitter and the second optical communication device serves as a receiver.

### Example 1:

The following describes in detail the solutions according to embodiments of this application with reference to FIG. 3. FIG. 3 is a schematic flowchart of a data transmission method provided in Example 1 according to an embodiment of this application.

S301: A first optical module obtains outer-encoded first data, where the first data is any data in a to-be-sent data stream. It may be understood that the to-be-sent data stream is a to-be-sent data stream in the first optical communication apparatus.

S302: The first optical module determines a first inner-code processing mode. The first inner-code processing mode is one of a plurality of configured inner-code processing modes. However, different inner-code processing modes in the plurality of inner-code processing modes have different processing manners. For example, the first optical module selects the first inner-code processing mode from the plurality of inner-code processing modes. In some scenarios, S302 may not be included. For example, the first inner-code processing mode may be pre-configured in the first optical module. After obtaining the outer-encoded first data, the first optical module performs S303.

S303: The first optical module performs transmitter inner-code processing on the first data in the first inner-code processing mode, to obtain first encoded data. The first encoded data described herein may be understood as data obtained through the inner-code processing and the outer-code processing. It should be noted that, herein, the first encoded data is used to name the first data on which the transmitter inner-code processing is performed, or another naming manner may be used. This is not specifically limited in embodiments of this application.

The first encoded data carries a first mode indication indicating the first inner-code processing mode, and the transmitter inner-code processing corresponding to the first inner-code processing mode includes at least inner encoding and pad processing. The first inner-code processing mode may be understood as an inner-code processing mode in which the transmitter inner-code processing is not skipped. For example, the first mode indication may be carried in a pad (PAD) sequence of the first encoded data. It may be understood that when performing PAD insertion in the transmitter inner-code processing, the first optical module inserts the first mode indication into the PAD sequence. A position of the mode indication in the PAD sequence is not limited in embodiments of this application. For example, the mode indication may be inserted after a synchronization sequence and adjacent to the synchronization sequence, or may be inserted into another position. In some possible scenarios, the PAD sequence of the first encoded data may carry N first mode indications, in other words, in a PAD insertion process, the N first mode indications are inserted into the PAD sequence, so that mode identification efficiency of the receiver can be improved. That the pad sequence of the first encoded data carries the N first mode indications may also be understood as that the pad sequence of the first encoded data carries N copies of the first mode indication, where N is an integer greater than 1. It may also be understood as that the first mode indication is repeatedly padded to the pad sequence of the first encoded data for N times.

In an example, an example in which a frame structure (or a data structure) is 3264*128 bits+384 bits is used, as shown in FIG. 4. The 384 bits are used as a PAD sequence. Each 128 bits can be considered as one forward error correction (forward error correction, FEC) encoded code block. The first optical module periodically adds the PAD sequence to the data stream. For example, the frame structure shown in FIG. 4 is used as an example. Hamming (hamming) codeword-based (128, 120) encoding is used for an inner code, and 384 PAD bits (namely, a PAD sequence) are inserted at an interval of 3264 codewords of inner code (128, 120) (codewords of inner code or inner codewords). In some other embodiments, 1024 PAD bits may alternatively be inserted at an interval of 8704 codewords of inner code (128, 120). The PAD bits may further include a framing sequence (framing sequence, FS), an alignment marker (alignment marker, AM), a cyclic redundancy checksum (cyclic redundancy checksum, CRC), and the like.

AM and CRC bits are insufficient to fill a bandwidth of the PAD sequence. Based on this, in embodiments of this application, the mode indication is added to the PAD sequence, so that the mode indication does not need to occupy an extra out-of-band signal for transmission, resource utilization can be improved, and a data baud rate of the transmitter is not changed.

For example, the first optical module may select one inner-code processing mode from the plurality of configured inner-code processing modes for configuration. A quantity of bits (or a bit width) occupied by a mode indication corresponding to the inner-code processing mode may be configured based on a quantity of the configured inner-code processing modes. In an example, the configured inner-code processing modes include a full-encoding and interleaving mode and a convolutional interleaving transparent mode, and a value of a mode indication corresponding to each of the two inner-code processing modes may be configured by using one bit. For example, refer to Table 1. A correspondence between a value of a mode indication and an inner-code processing mode in Table 1 is merely used as an example. For example, alternatively, 1 may represent the full-encoding and interleaving mode, and 0 may represent the convolutional interleaving transparent mode. For the two inner-code processing modes, the mode indication may alternatively be configured by using two bits, for example, as shown in Table 2. A signal finally used for channel transmission may use pulse amplitude modulation (pulse amplitude modulation, PAM)4 symbols, and each symbol includes two bits. Therefore, the mode indication may alternatively be represented by using two bits. For example, 00 and 10 shown in Table 2 may be used, that is, correspond to two symbols, with lower bit error rates, of a PAM4 signal in channel transmission. Certainly, any two symbols in {00, 01, 11, 10} may alternatively be used as the mode indications of the two inner-code processing modes. In another example, two configured inner-code processing modes may include a full-encoding and interleaving mode and a semi-encoding and interleaving mode, and a bit width of a mode indication corresponding to each of the two inner-code processing modes may be one bit or two bits, or certainly may be a larger bit width. For a specific configuration of the correspondence, refer to the configuration manners in Table 1 and Table 2. Details are not described herein again.

**Table 1**

| Inner-code processing mode | Mode indication (single bit) |
|---|---|
| Full-encoding and interleaving mode | 0 |
| Convolutional interleaving transparent mode | 1 |

**Table 2**

| Inner-code processing mode | Mode indication (dual bits) |
|---|---|
| Full-encoding and interleaving mode | 00 |
| Convolutional interleaving transparent mode | 10 |

In still another example, the configured inner-code processing modes include a full-encoding and interleaving mode, a convolutional interleaving transparent mode, and a semi-encoding and interleaving mode. A mode indication corresponding to each of the foregoing three inner-code processing modes may use a bit width of two bits, or certainly may use a bit width of more bits. This is not limited in embodiments of this application. For example, refer to Table 3.

**Table 3**

| Inner-code processing mode | Mode indication |
|---|---|
| Full-encoding and interleaving mode | 00 |
| Semi-encoding and interleaving mode | 01 |
| Convolutional interleaving transparent mode | 10 |

It should be noted that the correspondence between the inner-code processing mode and the mode indication in Table 1 to Table 3 is not unique, but needs to be a one-to-one correspondence. In addition, there may be more than four configured inner-code processing modes, and a mode indication with a wider bit width may be used. Specific relationships are not listed one by one.

S304: The first optical module outputs the first encoded data.

S305: After receiving the first encoded data, a second optical module performs receiver inner-code processing on the first encoded data in the first inner-code processing mode. After receiving the first encoded data, the second optical module may detect a mode of the first encoded data, obtain the first mode indication from the PAD sequence, and perform the receiver inner-code processing on the first encoded data in the first inner-code processing mode indicated by the first mode indication.

In a possible implementation, the first encoded data may further carry a decoding indication indicating a decoding manner used in the first inner-code processing mode, and the decoding manner is hard decoding or soft decoding. Further, when inner decoding is performed in a process of performing the receiver inner-code processing on the first encoded data in the first inner-code processing mode, the inner decoding may be performed in the hard decoding or soft decoding manner based on the decoding indication. The hard decoding may be understood as inner decoding performed by using hardware. The soft decoding may be understood as inner decoding performed by using a software algorithm. In addition, in embodiments of this application, one mode indication may indicate a used inner-code processing mode, and further indicate a used decoding manner in the inner-code processing mode. For example, one value of a mode indication indicates that the full-encoding and interleaving mode is used, and the hard encoding is used in the full-encoding and interleaving mode, and the other value of the mode indication indicates that the full-encoding and interleaving mode is used, and the soft encoding is used in the full-encoding and interleaving mode. This implementation is also applicable to another example. In the another example, details are not described again.

In some embodiments, when the first encoded data includes a plurality of (for example, N) copies of the first mode indication, after obtaining J copies of the first mode indication by successively parsing the first encoded data, the second optical module may identify the first mode indication based on a big data decision or a weighted average policy of soft information, to improve decoding accuracy of the first mode indication. J is less than or equal to N. Then, the second optical module determines, based on the first inner-code processing mode indicated by the first mode indication, whether to perform circular shift and convolutional interleaving (including determining a depth of the convolutional interleaving). It should be noted that an inner-code processing manner of the receiver corresponds one-to-one to an inner-code processing manner of the transmitter. For example, if the transmitter uses the full-encoding and interleaving mode, the receiver also uses a full decoding and interleaving mode. For another example, if the transmitter skips the convolutional interleaving, the receiver also skips convolutional de-interleaving.

Based on the foregoing descriptions, addition of the mode indication may be performed in the PAD insertion. The first mode indication is used as an example. The transmitter inner-code processing corresponding to the first inner-code processing mode includes at least the pad processing and channel interleaving, and the pad processing includes addition of the first mode indication indicating the first inner-code processing mode. In one manner, the pad processing may be after the channel interleaving, as shown in FIG. 2A. In another manner, the pad processing is before the channel interleaving, as shown in FIG. 2B.

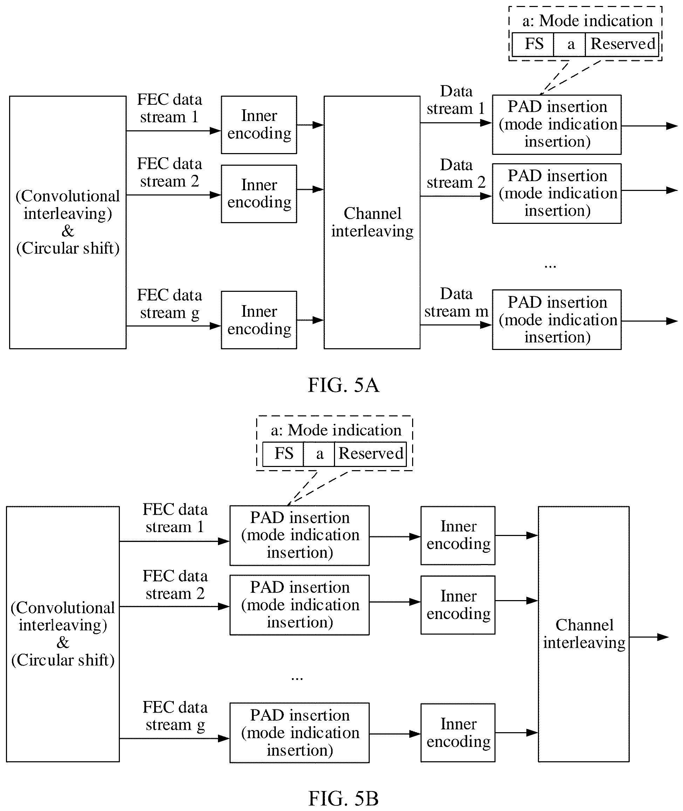

A mode indication insertion procedure is described below with reference to FIG. 5A and FIG. 5B.

Refer to FIG. 5A. An example in which pad processing is after channel interleaving is used. A data stream obtained through inner encoding and the channel interleaving is described with reference to the first data in the to-be-sent data stream in FIG. 3. The transmitter inner-code processing is performed on the outer-encoded first data in the first inner-code processing mode. For example, m data streams obtained through the channel interleaving may also be understood as data streams of m lanes, where, for example, m=4. For example, a baud rate of the m data streams is 113.33 GBd. Then, for each data stream, a 384-bit PAD sequence, including a 360-bit PAD sequence data part and a 24-bit check part, is inserted at an interval of 3264 codewords of inner code (128, 120). In embodiments of this application, a mode indication (for example, the first mode indication) may be padded to any position of another PAD sequence data part. It may be understood that the PAD sequence in the first encoded data includes the mode indication (namely, the first mode indication). In an insertion process, N copies (N≥1) of the mode indication may alternatively be inserted into the PAD sequence, to improve mode identification efficiency of the receiver.

Refer to FIG. 5B. A mode indication may alternatively be added to each FEC data stream before channel interleaving. The mode indication is inserted into each of g data streams on which convolutional interleaving and circular shift are performed. In an insertion process, N copies (N≥1) of the mode indication may alternatively be inserted into a PAD sequence, to improve mode identification efficiency of the receiver. Because all the FEC data stream uses a same data encoding mode, the inserted mode indications are also the same. After the PAD insertion is completed, the channel interleaving is performed by using every k data streams as a group, and finally m 113.4375 GB data streams are formed and enter a channel (k=g/m). A PAD insertion interval herein is that 1024 PAD bits are inserted at an interval of 8704 codewords of inner code (128, 120). In this embodiment, bit data of the mode indication is included in the 1024 PAD bits, and no new redundancy needs to be generated. Similarly, in this solution, the bit data of the mode indication may be padded to a PAD sequence data part.

The following describes the second possible transmission manner with reference to Example 2 and Example 3. In the second possible transmission manner, there is a backchannel between a transmitter and a receiver.

### Example 2:

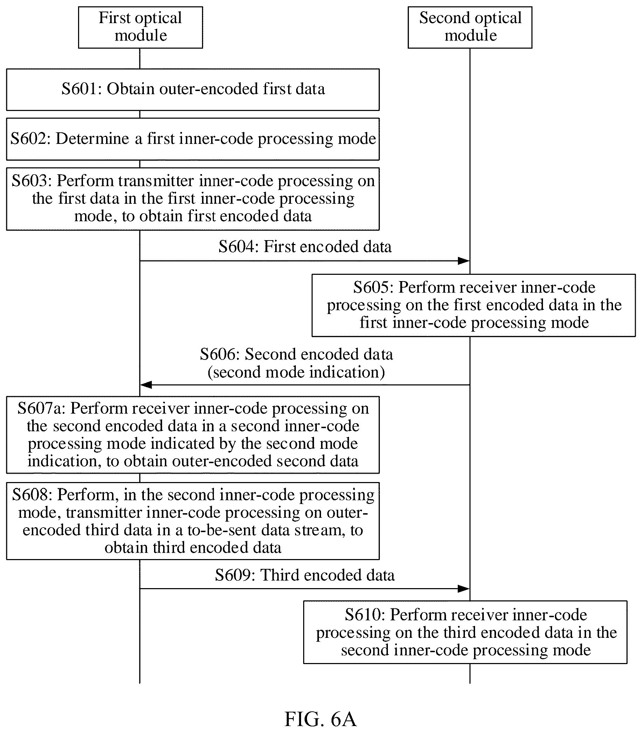

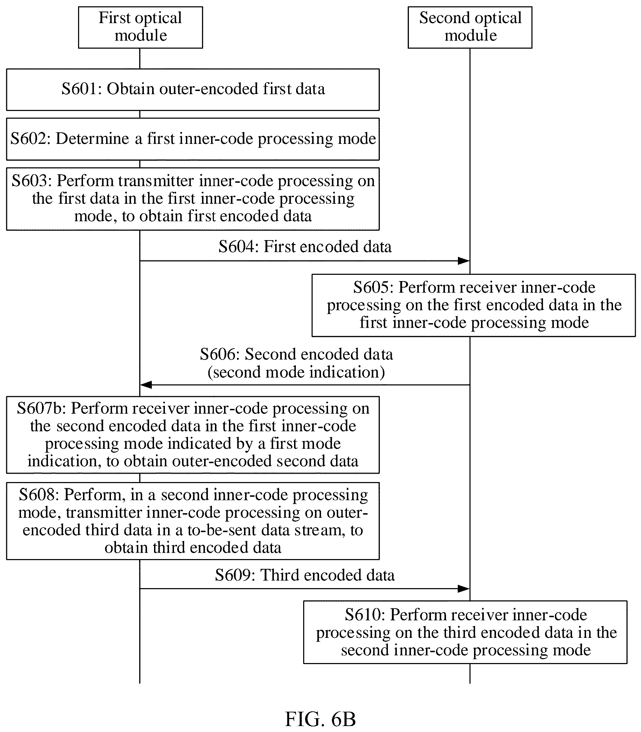

FIG. 6A and FIG. 6B each are a schematic flowchart of a data transmission method according to an embodiment of this application.

For S601 to S605, refer to S301 to S305. Details are not described herein again. In Example 2, it may be understood that the first inner-code processing mode indicated by the first mode indication carried in the first encoded data is an inner-code processing mode selected by the first optical module. The second optical module may detect whether quality of a current link (or channel) matches the inner-code processing mode indicated by the first mode indication. For example, the second optical module may detect quality of a link between the first optical communication apparatus and the second optical communication apparatus based on the first encoded data received from the first optical module.

The following provides several examples of link quality detection manners.

### Manner 1: Syndrome (syndrome) detection.

The receiver performs syndrome detection on several consecutive codewords (the codeword may also be referred to as code blocks), and performs statistics collection on a quantity or a proportion of non-zero syndromes. For example, a Hamming code-based encoding manner is used for inner encoding. The receiver may perform syndrome detection on several consecutive inner codewords, perform statistics collection on a quantity or a proportion of non-zero syndromes, and then determine a matched inner-code processing mode by comparing the quantity or proportion with a specified quantity threshold or proportion threshold.

The first encoded data is used as an example. In a process of performing inner decoding on the first encoded data, the second optical module determines a first quantity of non-zero syndromes in syndromes of N1 consecutive codewords (namely, inner codewords) in the first encoded data. The first quantity is within a first quantity range corresponding to an inner-code processing mode in the plurality of inner-code processing modes, in other words, the inner-code processing mode matches the link quality. In other words, the first quantity is within the first quantity range corresponding to the matched inner-code processing mode. Each of the plurality of inner-code processing modes corresponds to one first quantity range, and different inner-code processing modes correspond to different first quantity ranges, where N1 is an integer greater than 1.

Alternatively, in a process of performing inner decoding on the first encoded data, a first proportion of non-zero syndromes in syndromes of N2 consecutive codewords (namely, inner codewords) in the first encoded data is determined. The first proportion is within a first proportion range corresponding to an inner-code processing mode in the plurality of inner-code processing modes, in other words, the inner-code processing mode matches the link quality. In other words, the first proportion is within the first proportion range corresponding to the matched inner-code processing mode, each of the plurality of inner-code processing modes corresponds to one first proportion range, and different inner-code processing modes correspond to different first proportion ranges, where N2 is an integer greater than 1.

### Manner 2: Detection on bit inverting in inner decoding.

The receiver detects a quantity or a proportion of inverted (or corrected) bits in several consecutive codewords (that is, inner codewords). For example, a Hamming code-based encoding manner is used for inner encoding. Several consecutive inner codewords are decoded, a quantity or a proportion of inverted (corrected) bits in a decoding process is recorded, and then a matched inner-code processing mode is determined by comparing the quantity or proportion with a specified quantity threshold or proportion threshold.

The first encoded data is used as an example. In a process in which the second optical module performs inner decoding on N3 consecutive bits in the first encoded data, a determined quantity of corrected bits is within a second quantity range corresponding to the matched inner-code processing mode, each of the plurality of inner-code processing modes corresponds to one second quantity range, and different inner-code processing modes correspond to different second quantity ranges, where N3 is an integer greater than 1; or
in a process in which the second optical module performs inner decoding on N4 consecutive bits in the first encoded data, a determined second proportion of a quantity of corrected bits to the N3 bits is within a second proportion range corresponding to the matched inner-code processing mode, each of the plurality of inner-code processing modes corresponds to one second proportion range, and different inner-code processing modes correspond to different second proportion ranges, where N4 is an integer greater than 1.

### Manner 3: Statistics collection on a quantity or proportion of uncorrectable inner codewords.

After performing decoding check on several consecutive codewords (which may also be understood as inner codewords), the receiver performs statistics collection on a quantity or a proportion of codewords whose syndromes are still non-zero (namely, error correction-failed inner codewords). For example, a Hamming code-based encoding manner is used for inner encoding. After inner decoding is performed on several consecutive inner codewords, statistics collection is performed on a quantity or a proportion of codewords whose syndromes are still non-zero, and an inner-code processing mode suitable for a current link quality is determined by comparing the quantity or proportion with a preset quantity threshold or proportion threshold.

Decoding of the first encoded data is still used as an example. In a process of performing inner decoding on N5 consecutive codewords of the first encoded data, a determined third quantity of error correction-failed codewords is within a third quantity range corresponding to the matched inner-code processing mode, each of the plurality of inner-code processing modes corresponds to one third quantity range, and different inner-code processing modes correspond to different third quantity ranges, where N5 is an integer greater than 1; or
in a process of performing inner decoding on N6 consecutive codewords of the first encoded data, a determined third proportion of error correction-failed codewords (namely, inner codewords) is within a third proportion range corresponding to the matched inner-code processing mode, each of the plurality of inner-code processing modes corresponds to one third proportion range, and different inner-code processing modes correspond to different third proportion ranges, where N6 is an integer greater than 1.

### Manner 4: Detection on a quantity or a proportion of uncorrectable codewords after outer decoding.

After completing processes such as inner decoding and convolutional de-interleaving based on the first mode indication extracted from the PAD sequence, the second optical module may obtain consecutive KP4 codeword data streams. The second optical module decodes consecutive KP4 codewords, performs statistics collection on uncorrectable codewords, and determines an inner-code processing mode suitable for current link quality by comparing a statistical result with a preset quantity threshold or proportion threshold.

Decoding of the first encoded data is still used as an example. After inner decoding and outer decoding are performed on N7 consecutive codewords of the first encoded data, a fourth quantity of determined error correction-failed codewords (for example, KP4 codewords) is within a fourth quantity range corresponding to the matched inner-code processing mode, each of the plurality of inner-code processing modes corresponds to one fourth quantity range, and different inner-code processing modes correspond to different fourth quantity ranges, where N7 is an integer greater than 1; or
after inner decoding and outer decoding are performed on N8 consecutive codewords of the first encoded data, a fourth proportion of determined error correction-failed codewords (for example, a KP4 codeword) is within a fourth proportion range corresponding to the matched inner-code processing mode, each of the plurality of inner-code processing modes corresponds to one fourth proportion range, and different inner-code processing modes correspond to different fourth proportion ranges, where N8 is an integer greater than 1.

Further, after determining the matched inner-code processing mode after detecting the link quality, for example, the matched inner-code processing mode corresponds to a second mode indication, the second optical module may feed back the matched inner-code processing mode to the first optical module through a backchannel. Further, S606 is performed.

S606: The second optical module sends second encoded data to the first optical communication apparatus, where the second encoded data carries the second mode indication. A second inner-code processing mode indicated by the second mode indication matches the link quality detected by the second optical module. In FIG. 6A, if the second encoded data is obtained by performing transmitter inner encoding in the inner-code processing mode indicated by the second mode, S607a is performed. In FIG. 6B, if the second encoded data is obtained by performing transmitter inner encoding still in the inner-code processing mode used before switching, S607b is performed.

It should be noted that the second mode indication may be the same as or different from the first mode indication. When the second mode indication is the same as the first mode indication, it may be understood that the link quality detected by the second optical module matches the inner-code processing mode indicated by the first mode indication. When the second mode indication is different from the first mode indication, it may be understood that the link quality detected by the second optical module does not match the inner-code processing mode indicated by the first mode indication.

S607a: After receiving the second encoded data, the first optical module performs receiver inner-code processing on the second encoded data in the second inner-code processing mode indicated by the second mode indication, to obtain outer-encoded second data. When performing transmitter inner-code processing on the outer-encoded second data, the second optical module uses the second inner-code processing mode indicated by the second mode indication.

S607b: After receiving the second encoded data, the first optical module performs receiver inner-code processing on the second encoded data in the first inner-code processing mode indicated by the first mode indication, to obtain outer-encoded second data.

S608: After performing decoding in receiver inner-code processing on the second encoded data to obtain the second mode indication, the first optical module performs, in the inner-code processing mode indicated by the second mode indication, transmitter inner-code processing on outer-encoded third data in the to-be-sent data stream, to obtain third encoded data.

S609: The first optical module sends the third encoded data to the second optical module.

S610: After receiving the third encoded data, the second optical module performs receiver inner-code processing on the third encoded data in the second inner-code processing mode.

In some possible implementations, the inner-code processing mode indicated by the second mode indication in the solution shown in FIG. 6A includes at least inner encoding and PAD insertion. In this implementation, in a process of performing S608, the first optical module may further insert the second mode indication into the third encoded data when performing the transmitter inner-code processing.

In some other possible implementations, the solution shown in FIG. 6B is applicable to a solution in which the inner-code processing mode indicated by the second mode indication includes at least inner encoding and PAD insertion, and is also applicable to a solution in which the inner-code processing mode indicated by the second mode indication is skipping the inner-code processing. If the inner-code processing mode indicated by the second mode indication is the skip mode, when performing S608, the first optical module performs the transmitter inner-code processing, in the inner-code processing mode indicated by the second mode indication, on the outer-encoded third data in the to-be-sent data stream, in other words, skips the transmitter inner-code processing in the inner-code processing mode indicated by the second mode indication. In this way, after receiving the third encoded data, the second optical module may skip the receiver inner-code processing.

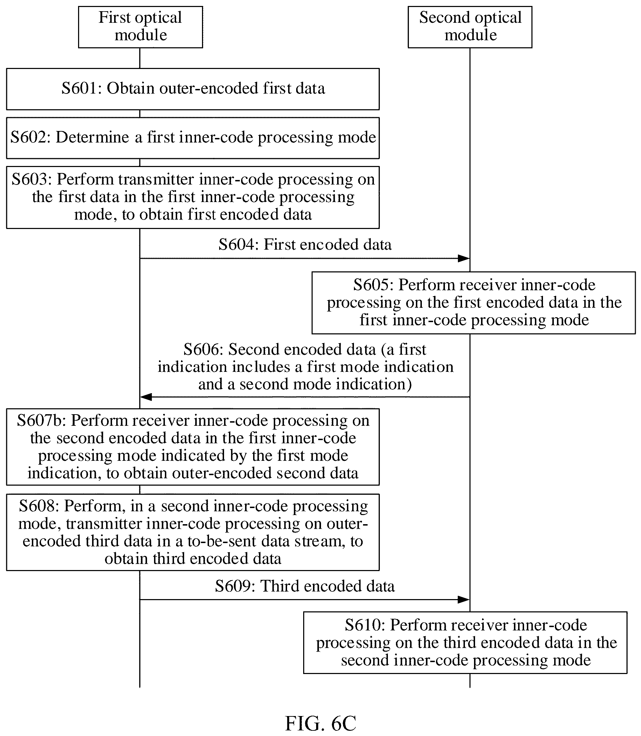

In some possible implementations, for the solution shown in FIG. 6B, to clearly indicate, to the first optical module, the inner-code processing mode used before the switching and the inner-code processing mode indicated after the switching, a first indication may be carried in the second encoded data, and the first indication includes the first mode indication indicating the inner-code processing mode used before the switching and the second mode indication indicating the inner-code processing mode used after the switching, as shown in FIG. 6C. A difference between FIG. 6C and FIG. 6B lies in that in FIG. 6C, the second encoded data carries the first indication, and in FIG. 6B, the second encoded data carries the second mode indication.

### Example 3:

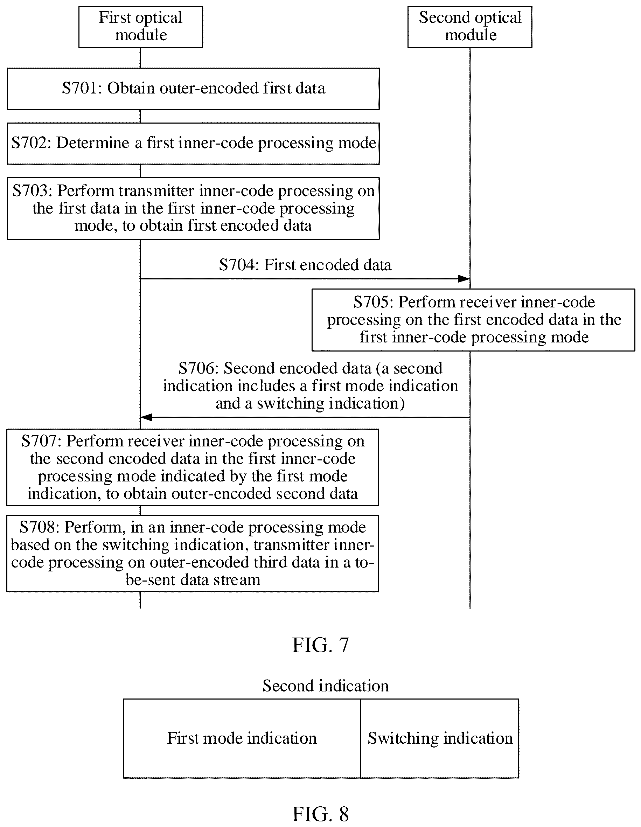

FIG. 7 is a schematic flowchart of a data transmission method provided in Example 3 according to an embodiment of this application. In Example 2, the second optical module uses an explicit indication manner. In Example 3, an indirect indication manner is used, to indicate whether an inner-code processing mode indicated by a transmitter matches current link quality.

For S701 to S705, refer to S301 to S305. Details are not described herein again.

S706: The second optical module sends second encoded data to the first optical communication apparatus (the first optical module), where the second encoded data carries a second indication. In a process in which the second optical module performs inner-code processing on the second encoded data, the transmitter inner-code processing may be performed, in the first inner-code processing mode indicated by the first mode indication, as indicated by the first optical module.

Refer to FIG. 8. The second indication includes two parts. A first half is a copy of the first mode indication, and a second half is a switching indication. In other words, the second indication includes the first mode indication and the switching indication.

In a first possible manner, the switching indication indicates whether detected link quality matches link quality indicated by the first mode indication. When the switching indication is of a first value, it indicates that the first inner-code processing mode matches the link quality detected by the second optical module. When the switching indication is of a second value, it indicates that the first inner-code processing mode does not match the link quality detected by the second module. In an example, as shown in Table 4, the switching indication may occupy a bit width of only one bit. For example, 0 represents mismatching (switching), and 1 represents matching (no switching). For another example, 1 represents mismatching, and 0 represents matching. In another example, the switching indication may occupy a bit width of two bits, for example, may be represented by 00 and 10. For example, 00 represents mismatching, and 10 represents matching. For another example, 10 represents mismatching, and 00 represents matching. The switching indication may use any two of 00, 01, 10, and 11. This is not specifically limited in embodiments of this application. The bit width occupied by the switching indication is not specifically limited in embodiments of this application.

**Table 4**

| Switching indication | Mode indication |
|---|---|
| No switching (a current inner-code processing mode satisfies the link quality) | 0 |
| Switching (a current inner-code processing mode does not satisfy the link quality) | 1 |

In a second possible manner, the switching indication indicates whether to perform switching and a switching direction. When the switching indication is of a first value, it indicates that the first inner-code processing mode matches quality that is of a link and that is detected by the second optical communication apparatus; when the switching indication is of a third value, it indicates to switch to an inner-code processing mode whose delay or performance (error correction capability) is greater than the first inner-code processing mode; or when the switching indication is of a fourth value, it indicates to switch to an inner-code processing mode whose delay or performance (error correction capability) is less than the first inner-code processing mode, where the link is a link for communication between the first optical communication apparatus and the second optical communication apparatus. In an example, as shown in Table 5, the switching indication may occupy a bit width of two bits. For example, 00 represents no switching, 10 represents to switch to an inner-code processing mode whose delay or performance (error correction capability) is greater than the first inner-code processing mode, and 11 represents to switch to an inner-code processing mode whose delay or performance (error correction capability) is less than the first inner-code processing mode. The switching indication may use any three of 00, 01, 10, and 11. This is not specifically limited in embodiments of this application. The bit width occupied by the switching indication is not specifically limited in embodiments of this application.

**Table 5**

| Switching indication | Mode indication |
|---|---|
| No switching (a current inner-code processing mode satisfies the link quality) | 00 |
| Mode upward switching (switching to an inner-code processing mode whose delay/error correction capability is greater than the first inner-code processing mode) | 10 |
| Mode downward switching (switching to an inner-code processing mode whose delay/error correction capability is less than the first inner-code processing mode) | 11 |

For S707, refer to S607b. Details are not described herein again.

S708: After receiving the second encoded data, the first optical module performs, in the inner-code processing mode based on the switching indication, transmitter inner-code processing on outer-encoded third data in the to-be-sent data stream.

In the foregoing first possible manner, when the switching indication is of the first value, a third inner-code processing mode is the first inner-code processing mode; or when the switching indication is of the second value, a third inner-code processing mode is an inner-code processing mode other than the first inner-code processing mode in the plurality of inner-code processing modes. It may be understood that when the switching indication is of the first value, the switching is not performed, and the transmitter inner-code processing continues to be performed on the data in the data stream in the first inner-code processing mode indicated by the first mode indication. When the switching indication is of the second value, the switching is performed, and an inner-code processing mode other than the first inner-code processing mode is selected from the plurality of configured inner-code processing modes. In an example, when there are two configured inner-code processing modes, when the switching indication is of the second value, an inner-code processing mode other than the inner-code processing mode indicated by the first mode indication is directly used to perform the transmitter inner-code processing on a data stream of the transmitter.

In the foregoing second possible manner, when the switching indication is of the first value, a third inner-code processing mode is the same as the first inner-code processing mode; when the switching indication is of the third value, a delay or performance (an error correction capability) of the third inner-code processing mode is greater than a delay or performance (an error correction capability) of the first inner-code processing mode; or when the switching indication is of the fourth value, a delay or performance (an error correction capability) of the third inner-code processing mode is less than a delay or performance (an error correction capability) of the first inner-code processing mode.

### Example 4:

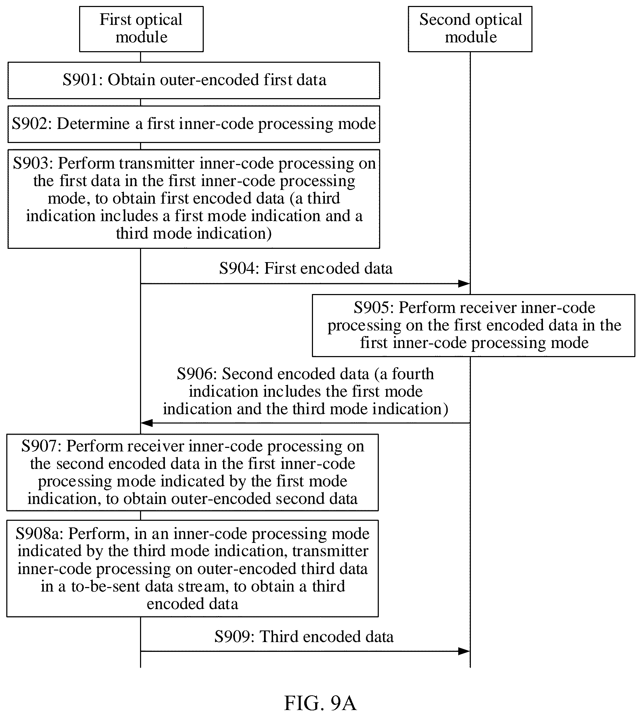

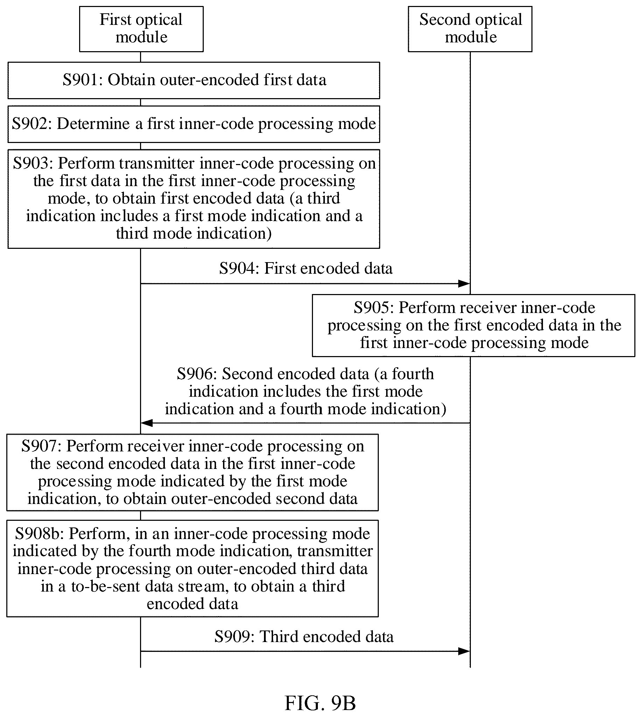

FIG. 9A and FIG. 9B each are a schematic flowchart of a data transmission method according to an embodiment of this application. In Example 4, a first optical module and a second optical module use a negotiation manner. The first optical module indicates an inner-code processing mode used by the second optical module and a to-be-negotiated inner-code processing mode in a negotiation process.

For S901 and S902, refer to S301 and S302. Details are not described herein again.

S903: The first optical module performs transmitter inner-code processing on the first data in the first inner-code processing mode, to obtain first encoded data. The first encoded data described herein may be understood as data obtained through the inner-code processing and the outer-code processing.

The first encoded data carries a third indication, the third indication includes a first mode indication, the first inner-code processing mode indicated by the first mode indication is an inner-code processing mode used in a negotiation process, the third indication further includes a third mode indication, and the third mode indication indicates a to-be-negotiated inner-code processing mode.

For S904 and S905, refer to S304 and S305. Details are not described herein again.

S906: The second optical module sends second encoded data to the first optical communication apparatus (the first optical module), where the second encoded data carries a fourth indication.

In this embodiment, the second encoded data is obtained by the second optical module by performing transmitter inner-code processing in the first inner-code processing mode indicated by the first mode indication in the transmitter inner-code processing.

When the inner-code processing mode indicated by the third mode indication matches quality that is of a link and that is detected by the second optical module, the fourth indication includes the first mode indication and the third mode indication, and transmitter inner-code processing is performed, in the inner-code processing mode indicated by the third mode indication, on outer-encoded third data in the data stream. Alternatively, when the inner-code processing mode indicated by the third mode indication does not match quality that is of a link and that is detected by the second optical module, the fourth indication includes the first mode indication and a fourth mode indication, where an inner-code processing mode indicated by the fourth mode indication matches the quality that is of the link and that is detected by the second optical module; and transmitter inner-code processing is performed on outer-encoded third data in the inner-code processing mode indicated by the fourth mode indication.

In addition, a manner of determining the link quality and the matched inner-code processing mode may be described above. Details are not described herein again.

For S907, refer to S607b. Details are not described herein again.

S908a: When the fourth indication includes the third mode indication, the first optical module performs, in the inner-code processing mode indicated by the third mode indication, the transmitter inner-code processing on the outer-encoded third data in the to-be-sent data stream, to obtain third encoded data. Correspondingly, the second optical module performs receiver inner-code processing on the third encoded data in the inner-code processing mode indicated by the third mode indication.

**In** some embodiments, the inner-code processing mode indicated by the third mode indication may be an inner-code processing mode in which the transmitter inner-code processing is skipped, or may be an inner-code processing mode in which the transmitter inner-code processing is not skipped.

S908b: When the fourth indication includes the fourth mode indication, the first optical module performs, in the inner-code processing mode indicated by the fourth mode indication, the transmitter inner-code processing on the outer-encoded third data in the to-be-sent data stream, to obtain a third encoded data. Correspondingly, the second optical module performs receiver inner-code processing on the third encoded data in the inner-code processing mode indicated by the fourth mode indication. In some embodiments, the inner-code processing mode indicated by the fourth mode indication may be an inner-code processing mode in which the transmitter inner-code processing is skipped, or may be an inner-code processing mode in which the transmitter inner-code processing is not skipped.

S909: The first optical module sends the third encoded data to the second optical module.

### Example 5:

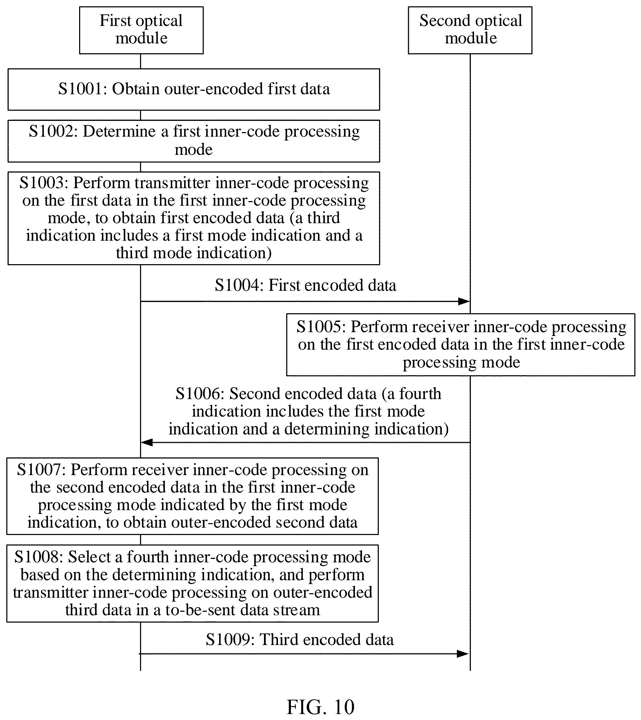

FIG. 10 is a schematic flowchart of a data transmission method according to an embodiment of this application. In Example 5, a first optical module and a second optical module use a negotiation manner. A difference between Example 5 and Example 4 lies in that the fourth indication fed back by the second optical module does not explicitly indicate the determined inner-code processing mode, but indicates whether to use the to-be-negotiated inner-code processing mode indicated by the first optical module.

For S1001 to S1005, refer to S901 to S905. Details are not described herein again.

S 1006: The second optical module sends second encoded data to the first optical communication apparatus (the first optical module), where the second encoded data carries a fourth indication.

In this embodiment, the second encoded data is obtained by the second optical module by performing transmitter inner-code processing in the first inner-code processing mode indicated by the first mode indication in the transmitter inner-code processing.

The fourth indication includes the first mode indication and a determining indication. When the determining indication is of a first value, it indicates that the third mode indication matches quality that is of a link and that is detected by the second optical communication apparatus; or when the determining indication is of a second value, it indicates that the third mode indication does not match quality that is of a link and that is detected by the second optical communication apparatus, where the link is a link for communication between the first optical communication apparatus and the second optical communication apparatus.

In addition, a manner of determining the link quality and the matched inner-code processing mode may be described above. Details are not described herein again.

For S1007, refer to S907. Details are not described herein again.

S1008: The first optical module selects a fourth inner-code processing mode based on the determining indication, and performs transmitter inner-code processing on outer-encoded third data in the to-be-sent data stream, to obtain a third encoded data.

In some embodiments, the inner-code processing mode indicated by the third mode indication may be an inner-code processing mode in which the transmitter inner-code processing is skipped, or may be an inner-code processing mode in which the transmitter inner-code processing is not skipped.

When the determining indication is of the first value, the fourth inner-code processing mode is the inner-code processing mode indicated by the third mode indication. Alternatively, when the determining indication is of the second value, the fourth inner-code processing mode is an inner-code processing mode other than the inner-code processing mode indicated by the third mode indication.

S1009: The first optical module sends the third encoded data to the second optical module.

The following describes the third possible transmission manner. An inner-code processing mode selected by a transmitter is skipping transmitter inner-code processing, and a host adds a mode indication to data in an outer-code processing process.

### Example 6:

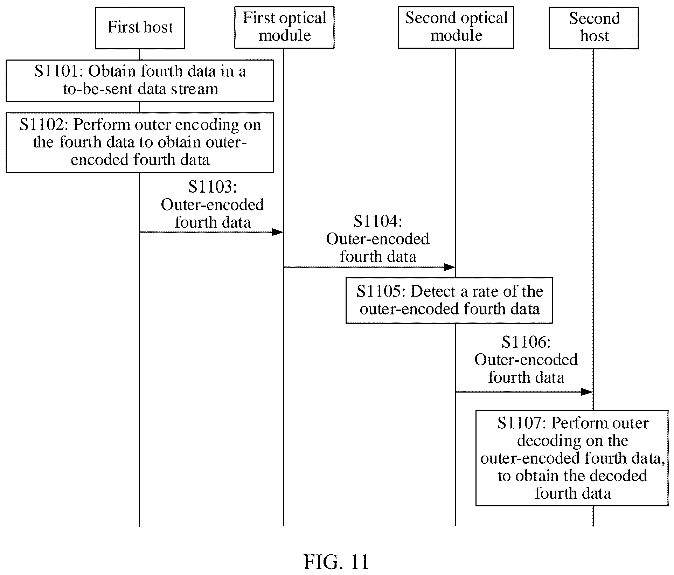

The following describes in detail, with reference to FIG. 11, the solution provided in Example 6 according to an embodiment of this application. FIG. 11 is a schematic flowchart of a data transmission method provided in Example 6 according to an embodiment of this application. Example 6 may be specific to a full transparent transmission inner-code processing scenario, and a receiver may be directly indicated to perform full transparent transmission inner-code processing, in other words, skip transmitter/receiver inner-code processing.

When a transmitter selects any mode other than the full transparent transmission inner-code processing, any possible solution in Example 1 and Example 2 may be used. When an optical module of the transmitter selects the full transparent transmission inner-code processing mode (which may also be referred to as an inner-code processing transparent transmission mode), the transmitter skips a transmitter inner-code processing operation. Therefore, the optical module of the transmitter cannot indicate the inner-code processing mode from a PAD sequence, and an optical module of the receiver cannot identify a mode indication from a PAD signal. Therefore, when the transmitter skips the transmitter inner-code processing, the optical module of the receiver may identify, through rate detection, whether the transmitter uses the full transparent transmission inner-code processing mode. If not, the manner in Example 2 or Example 3 is used for subsequent processing.

S1101: A first host obtains fourth data from a to-be-sent data stream. The fourth data may be understood as current to-be-sent data in the to-be-sent data stream.

S1102: The first host performs outer encoding on the fourth data to obtain outer-encoded fourth data.

S1103: The first host sends the outer-encoded fourth data to a first optical module.

S1104: The first optical module skips the transmitter inner-code processing on the outer-encoded fourth data, and outputs the outer-encoded fourth data (to a second optical module). In some embodiments, the first optical module may perform electrical and optical processing on the outer-encoded fourth data and then output the fourth data.

S1105: After receiving the outer-encoded fourth data, the second optical module detects a rate of the outer-encoded fourth data.

S1106: When determining, based on the rate of the outer-encoded fourth data, that a used inner-code processing mode is skipping receiver inner-code processing, the second optical module skips the receiver inner-code processing on the outer-encoded fourth data, and sends the outer-encoded fourth data to a second host.

S1107: The second host performs outer decoding on the outer-encoded fourth data, to obtain the decoded fourth data.

In some possible embodiments, the outer-encoded fourth data carries a fourth mode indication indicating a fourth inner-code processing mode, and the fourth inner-code processing mode indicates the first optical module to skip the transmitter inner-code processing. In this way, the second host may also obtain the fourth mode indication in an outer decoding process, and notify the second optical module of the fourth mode indication. Subsequently, after receiving data of the first optical module, the second optical module does not perform the receiver inner-code processing based on a mode that is of skipping inner-code processing and that is indicated by the fourth mode indication, and the transmitter inner-code processing is not performed on the sent data.

In some embodiments, the second host may further determine link quality in the outer decoding process. In a process of performing outer decoding on M1 consecutive code blocks of the outer-encoded fourth data, a determined quantity of error correction-failed code blocks is within a quantity range corresponding to a matched inner-code processing mode, each of the plurality of inner-code processing modes corresponds to one quantity range, and different inner-code processing modes correspond to different quantity ranges, where M1 is an integer greater than 1. Alternatively, in a process of performing inner decoding and outer decoding on M2 consecutive code blocks of the outer-encoded fourth data, a determined proportion of error correction-failed code blocks is within a proportion range corresponding to a matched inner-code processing mode, each of the plurality of inner-code processing modes corresponds to one proportion range, and different inner-code processing modes correspond to different proportion ranges, where M2 is an integer greater than 1. Further, in a PAD insertion process of outer encoding, the second host may add a determined mode indication indicating the matched inner-code processing mode to a PAD sequence of an outer code or a 3-bit status field (status field) signal. The second optical communication device may alternatively transmit back the mode indication indicating the selected inner-code processing mode in another manner, for example, the manner shown in Example 2. This is not described herein again.

The following describes a fourth possible implementation with reference to the accompanying drawings.

### Example 7:

A host side of a transmitter may determine a to-be-used inner-code processing mode manner to perform inner-code processing. The determined and selected inner-code processing mode may be an inner-code processing transparent transmission mode, or may be another inner-code processing mode. In a possible implementation, if the host side of the transmitter selects the inner-code processing transparent transmission mode, the transmitter may directly notify an optical module of the transmitter to skip transmitter inner-code processing. In another possible implementation, if the inner-code processing mode selected by the host side of the transmitter is not the inner-code processing transparent transmission mode, the host side of the transmitter first negotiates the inner-code processing mode with a host side of a receiver, and then indicates the inner-code processing mode to an optical module after the negotiation. In still another possible implementation, if the inner-code processing mode selected by the host side of the transmitter is not the inner-code processing transparent transmission mode, the inner-code processing mode may be directly indicated to a receiver by using current to-be-sent data, and an optical module is indicated to use the inner-code processing mode during subsequent processing of to-be-sent data. In yet another possible implementation, regardless of whether the inner-code processing mode selected by the host side is the inner-code processing transparent transmission mode, the inner-code processing mode may be directly indicated to a receiver by using current to-be-sent data, and an optical module is indicated to use the inner-code processing mode during subsequent processing of to-be-sent data.

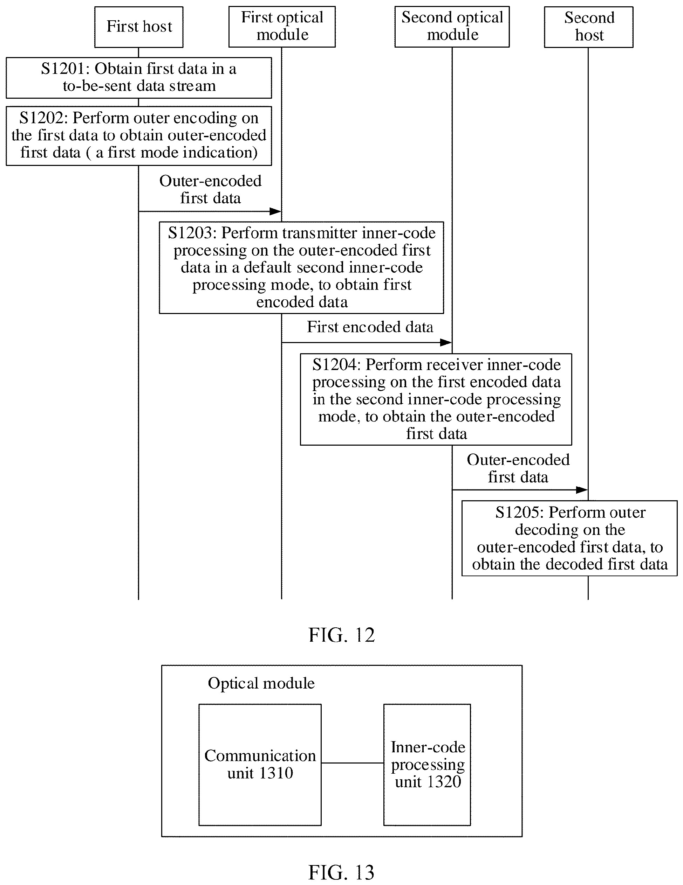

The following describes in detail, with reference to FIG. 12, the solution provided in Example 7 according to an embodiment of this application. FIG. 12 is a schematic flowchart of a data transmission method provided in Example 7 according to an embodiment of this application. Example 7 may be specific to a full transparent transmission inner-code processing scenario, and a receiver may be directly indicated to perform full transparent transmission inner-code processing, in other words, skip transmitter/receiver inner-code processing.

S1201: A first host obtains first data, where the first data is any data in a to-be-sent data stream.

S1202: The first host performs outer encoding on the first data to obtain outer-encoded first data, where the outer-encoded first data carries a first mode indication, the first mode indication indicates a to-be-negotiated first inner-code processing mode, the first inner-code processing mode is one of a plurality of configured inner-code processing modes, and different inner-code processing modes in the plurality of inner-code processing modes have different processing delays or performance (error correction capabilities).

For example, the first mode indication is carried in a pad sequence of the outer-encoded first data. For example, the first mode indication is carried in a pad sequence of a physical coding sublayer PCS. In some embodiments, to improve identification accuracy on a decoding side, N copies of the first mode indication are carried in the pad sequence of the outer-encoded first data, where N is an integer greater than 1.

S1203: A first optical module performs transmitter inner-code processing on the outer-encoded first data in a default second inner-code processing mode, to obtain first encoded data, and outputs the first encoded data to a second optical communication apparatus, where the second inner-code processing mode is a default inner-code processing mode in the plurality of inner-code processing modes, and the second inner-code processing mode includes at least inner encoding and pad processing.

S1204: A second optical module receives the first encoded data, and performs receiver inner-code processing on the first encoded data in the second inner-code processing mode, to obtain the outer-encoded first data.

S1205: A second host performs outer decoding on the outer-encoded first data, to obtain the decoded first data.

In a possible implementation, the second host indicates the second optical module to subsequently perform transmitter/receiver inner-code processing in the first inner-code processing mode, and the first host indicates the first optical module to subsequently perform transmitter/receiver inner-code processing in the first inner-code processing mode. The second optical module performs, in the first inner-code processing mode, transmitter inner encoding on to-be-sent outer-encoded second data, to obtain second encoded data, and sends the second encoded data to a first optical communication apparatus. After receiving the second encoded data, the first optical module may perform receiver inner-code processing on the second encoded data in the first inner-code processing mode, to obtain the outer-encoded second data. The first host performs outer decoding processing on the outer-encoded second data, to obtain decoded second data. For example, when performing outer encoding on the to-be-sent second data, the second host may encode, into the outer-encoded second data, the first mode indication indicating the first inner-code processing mode.

In another possible implementation, the second host may detect quality of a current link, and select an inner-code processing mode based on the quality. If the selected inner-code processing mode is the same as the first inner-code processing mode, the first host may be notified. For example, when performing outer encoding on to-be-sent second data, the second host may encode, into outer-encoded second data, the first mode indication indicating the first inner-code processing mode. The second optical module performs, in the first inner-code processing mode, transmitter inner encoding on the to-be-sent outer-encoded second data, to obtain second encoded data, and sends the second encoded data to a first optical communication apparatus. After receiving the second encoded data, the first optical module may perform receiver inner-code processing on the second encoded data in the first inner-code processing mode, to obtain the outer-encoded second data. The first host performs outer decoding processing on the outer-encoded second data, to obtain the decoded second data.

In still another possible implementation, the second host may detect quality of a current link, and select an inner-code processing mode based on the quality. If the selected inner-code processing mode is different from the first inner-code processing mode, the first host may be notified. For example, when performing outer encoding on to-be-sent second data, the second host may encode, into outer-encoded second data, a second mode indication indicating the selected inner-code processing mode. The second optical module performs, in the default second inner-code processing mode, transmitter inner encoding on the to-be-sent outer-encoded second data, to obtain second encoded data, and sends the second encoded data to a first optical communication apparatus. After receiving the second encoded data, the first optical module may perform receiver inner-code processing on the second encoded data in the default second inner-code processing mode, to obtain the outer-encoded second data. The first host performs outer decoding processing on the outer-encoded second data, to obtain the decoded second data. The first host may notify the first optical module of the inner-code processing mode indicated by the second mode indication. The second host may also notify the second optical module of the selected inner-code processing mode (namely, the inner-code processing mode indicated by the second mode indication). The first optical module subsequently performs, in the inner-code processing mode indicated by the second mode indication, transmitter inner-code processing on to-be-sent outer-encoded third data, and the second optical module also performs receiver inner-code processing in the inner-code processing mode.

In still another possible implementation, the second host may detect quality of a current link, and select an inner-code processing mode based on the quality. If the selected inner-code processing mode is different from the first inner-code processing mode, the first host may be notified, but inner-code processing may still be first performed in the indicated first inner-code processing mode, so that the first host subsequently switches the inner-code processing mode. For example, when performing outer encoding on to-be-sent second data, the second host may encode, into outer-encoded second data, a second mode indication indicating the selected inner-code processing mode. The second optical module performs, in the first inner-code processing mode, transmitter inner encoding on the to-be-sent outer-encoded second data, to obtain second encoded data, and sends the second encoded data to a first optical communication apparatus. After receiving the second encoded data, the first optical module may perform receiver inner-code processing on the second encoded data in the first inner-code processing mode, to obtain the outer-encoded second data. The first host performs outer decoding processing on the outer-encoded second data, to obtain the decoded second data. In this way, the first host may notify the first optical module of the inner-code processing mode indicated by the second mode indication. The second host may also notify the second optical module of the selected inner-code processing mode (namely, the inner-code processing mode indicated by the second mode indication). The first optical module subsequently performs, in the inner-code processing mode indicated by the second mode indication, transmitter inner-code processing on to-be-sent outer-encoded third data, and the second optical module also performs receiver inner-code processing in the inner-code processing mode. In some embodiments, when notifying the first host of the selected inner-code processing mode indicated by the second mode indication, the second host may indicate a currently used mode indication. In other words, a pad sequence of a PCS layer of the outer-encoded second data carries a first indication, and the first indication includes the first mode indication (indicating the currently used inner-code processing mode) and the second mode indication (indicating the inner-code processing mode used after switching).

In still another possible implementation, the second host may detect quality of a current link, determine whether the current quality matches the inner-code processing mode indicated by the first host, and then indicate to the first host based on a switching indication. In an example, when performing outer encoding on to-be-sent second data, the second host may encode a copy of the first mode indication and the switching indication into outer-encoded second data. The outer-encoded second data carries a second indication, and the second indication includes the first mode indication and the switching indication. When the switching indication is of a first value, it indicates that the first inner-code processing mode matches the quality that is of the link and that is detected by the second host; or when the switching indication is of a second value, it indicates that the first inner-code processing mode does not match the quality that is of the link and that is detected by the second host. In some scenarios, if the switching indication is of the second value, the first host may select an inner-code processing mode from inner-code processing modes other than the first inner-code processing mode, and then perform one round of negotiation. In some scenarios, when there are only two selectable inner-code processing modes, no further round of negotiation is required. In another example, the switching indication may also indicate a switching direction. For example, when the switching indication is of a first value, it indicates that the first inner-code processing mode matches the quality that is of the link and that is detected by the second host; when the switching indication is of a third value, it indicates to switch to an inner-code processing mode whose delay or performance (error correction capability) is greater than the first inner-code processing mode; or when the switching indication is of a fourth value, it indicates to switch to an inner-code processing mode whose delay or performance (error correction capability) is less than the first inner-code processing mode.

In embodiments of this application, when the second host detects the inner-code processing mode that matches the link quality, at least one of the following may be used: In a process of performing outer decoding on M1 consecutive code blocks of the first encoded data, a determined quantity of error correction-failed code blocks is within a quantity range corresponding to the matched inner-code processing mode, each of the plurality of inner-code processing modes corresponds to one quantity range, and different inner-code processing modes correspond to different quantity ranges, where M1 is an integer greater than 1; or in a process of performing outer decoding on M2 consecutive code blocks of the first encoded data, a determined proportion of error correction-failed code blocks is within a proportion range corresponding to the matched inner-code processing mode, each of the plurality of inner-code processing modes corresponds to one proportion range, and different inner-code processing modes correspond to different proportion ranges, where M2 is an integer greater than 1.

It should be noted that a sequence of the steps in the data processing method according to embodiments of this application may be appropriately adjusted, and a step may be correspondingly added or deleted based on a situation. Any variation method readily figured out by a person skilled in the art within the technical scope disclosed in this application shall fall within the protection scope of this application. Therefore, details are not described herein.

An embodiment of this application further provides an optical module. The optical module is configured to implement the method performed by the first optical module or the method performed by the second optical module in the data processing method according to embodiments of this application. FIG. 13 is a diagram of a structure of an optical module according to an embodiment of this application. The optical module includes a communication unit 1310 and an inner-code processing unit 1320.

In a possible application scenario, the optical module is configured to perform the method performed by the first optical module. Details are as follows:

The communication unit 1310 is configured to obtain outer-encoded first data, where the first data is any data in a to-be-sent data stream.

The inner-code processing unit 1320 is configured to: determine a first inner-code processing mode, where the first inner-code processing mode is one of a plurality of configured inner-code processing modes, and different inner-code processing modes in the plurality of inner-code processing modes have different processing manners; and perform transmitter inner-code processing on the first data in the first inner-code processing mode, to obtain first encoded data.

The communication unit 1310 is configured to output first encoded data, where the first encoded data carries a first mode indication indicating the first inner-code processing mode, and the transmitter inner-code processing corresponding to the first inner-code processing mode includes at least inner encoding and pad processing.

In a first possible implementation, the communication unit 1310 is further configured to receive second encoded data from a second optical communication apparatus, where the second encoded data carries a second mode indication, a second inner-code processing mode indicated by the second mode indication matches quality that is of a link and that is detected by the second optical communication apparatus, and the link is a link for communication between a first optical communication apparatus and the second optical communication apparatus. The inner-code processing unit 1320 is configured to perform, in the second inner-code processing mode, transmitter inner-code processing on outer-encoded third data in the data stream.

In some embodiments, the inner-code processing unit 1320 is further configured to: after the communication unit 1310 receives the second encoded data from the second optical communication apparatus, perform receiver inner-code processing on the second encoded data in the second inner-code processing mode, to obtain second data.

In some embodiments, the inner-code processing unit 1320 is further configured to: after the communication unit 1310 receives the second encoded data from the second optical communication apparatus, perform receiver inner-code processing on the second encoded data in the inner-code processing mode indicated by the first mode indication, to obtain second data.

In some embodiments, the second encoded data carries a first indication, and the first indication includes the first mode indication indicating the inner-code processing mode used before switching and the second mode indication indicating the inner-code processing mode used after the switching.

In a second possible implementation, the communication unit 1310 receives second encoded data from a second optical communication apparatus, where the second encoded data carries a second indication, and the second indication carries the first mode indication and a switching indication; and when the switching indication is of a first value, it indicates that the first inner-code processing mode matches quality that is of a link and that is detected by the second optical communication apparatus; or when the switching indication is of a second value, it indicates that the first inner-code processing mode does not match quality that is of a link and that is detected by the second optical communication apparatus, where the link is a link for communication between a first optical communication apparatus and the second optical communication apparatus. The inner-code processing unit 1320 performs, in a third inner-code processing mode based on switching indication, transmitter inner-code processing on outer-encoded third data in the data stream, where when the switching indication is of the first value, the third inner-code processing mode is the first inner-code processing mode; or when the switching indication is of the second value, the third inner-code processing mode is an inner-code processing mode other than the first inner-code processing mode in the plurality of inner-code processing modes.

In a third possible implementation, the communication unit 1310 receives second encoded data from a second optical communication apparatus, where the second encoded data carries a second indication, and the second indication carries the first mode indication and a switching indication; and when the switching indication is of a first value, it indicates that the first inner-code processing mode matches quality that is of a link and that is detected by the second optical communication apparatus; when the switching indication is of a second value, it indicates to switch to an inner-code processing mode whose delay or performance (error correction capability) is greater than that of the first inner-code processing mode; or when the switching indication is of a third value, it indicates to switch to an inner-code processing mode whose delay or performance (error correction capability) is less than that of the first inner-code processing mode, where the link is a link for communication between a first optical communication apparatus and the second optical communication apparatus; and the inner-code processing unit 1320 performs, in a third inner-code processing mode based on the switching indication, transmitter inner-code processing on outer-encoded third data in the data stream, where when the switching indication is of the first value, the third inner-code processing mode is the same as the first inner-code processing mode; when the switching indication is of the second value, a delay or performance (an error correction capability) of the third inner-code processing mode is greater than a delay or performance (an error correction capability) of the first inner-code processing mode; or when the switching indication is of the third value, a delay or performance (an error correction capability) of the third inner-code processing mode is less than a delay or performance (an error correction capability) of the first inner-code processing mode.

In a fourth possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode.

The communication unit 1310 receives second encoded data from a second optical communication apparatus, where the second encoded data carries a fourth indication, where
when the inner-code processing mode indicated by the third mode indication matches quality that is of a link and that is detected by the second optical communication apparatus, the fourth indication includes the first mode indication and the third mode indication; and the inner-code processing unit 1320 performs, in the inner-code processing mode indicated by the third mode indication, transmitter inner-code processing on outer-encoded third data in the data stream; or
when the inner-code processing mode indicated by the third mode indication does not match quality that is of a link and that is detected by the second optical communication apparatus, the fourth indication includes the first mode indication and a fourth mode indication, where an inner-code processing mode indicated by the fourth mode indication matches the quality that is of the link and that is detected by the second optical communication apparatus; and the inner-code processing unit 1320 performs transmitter inner-code processing on third data in the inner-code processing mode indicated by the fourth mode indication.

In a fifth possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode; and
the communication unit 1310 receives second data from a second optical communication apparatus, where the second data carries a fourth indication, and the fourth indication includes the first mode indication and a determining indication; and when the determining indication is of a first value, it indicates that the inner-code processing mode indicated by the third mode indication matches quality that is of a link and that is detected by the second optical communication apparatus; or when the determining indication is of a second value, it indicates that the inner-code processing mode indicated by the third mode indication does not match quality that is of a link and that is detected by the second optical communication apparatus, where the link is a link for communication between a first optical communication apparatus and the second optical communication apparatus; and the inner-code processing unit 1320 performs, in a third inner-code processing mode based on the determining indication, transmitter inner-code processing on third data, where when the determining indication is of the first value, the third inner-code processing mode is the inner-code processing mode indicated by the third mode indication; or when the determining indication is of the second value, the third inner-code processing mode is an inner-code processing mode other than the third inner-code processing mode in the plurality of inner-code processing modes.

In a possible implementation, the first encoded data further carries a decoding indication indicating a decoding manner used in the first inner-code processing mode, and the decoding manner is hard decoding or soft decoding.

In another possible application scenario, the optical module is configured to perform the method performed by the second optical module. Details are as follows:

The communication unit 1310 receives first encoded data from a first optical communication apparatus, where the first encoded data carries a first mode indication, a first inner-code processing mode indicated by the first mode indication is one of a plurality of configured inner-code processing modes, and different inner-code processing modes in the plurality of inner-code processing modes have different processing manners; and
the inner-code processing unit 1320 performs receiver inner-code processing on the first encoded data in the first inner-code processing mode, to obtain first data.

In a first possible implementation, the communication unit 1310 sends second encoded data to the first optical communication apparatus, where the second encoded data carries a second mode indication, a second inner-code processing mode indicated by the second mode indication matches quality that is of a link and that is detected by a second optical communication apparatus, and the link is a link for communication between the first optical communication apparatus and the second optical communication apparatus; and receives third encoded data from the first optical communication apparatus; and the inner-code processing unit 1320 performs receiver inner-code processing on the third encoded data in the second inner-code processing mode.

In some embodiments, the second encoded data carries a first indication, and the first indication includes the first mode indication indicating the inner-code processing mode used before switching and the second mode indication indicating the inner-code processing mode used after the switching.

In a second possible implementation, the communication unit 1310 sends second encoded data to the first optical communication apparatus, where the second encoded data carries a second indication, and the second indication carries the first mode indication and a switching indication; and when the switching indication is of a first value, it indicates that the inner-code processing mode indicated by the first mode indication matches quality that is of a link and that is detected by a second optical communication apparatus; or when the switching indication is of a second value, it indicates that the first mode indication does not match quality that is of a link and that is detected by a second optical communication apparatus, where the link is a link for communication between the first optical communication apparatus and the second optical communication apparatus.

In some embodiments, the communication unit 1310 receives third encoded data from the first optical communication apparatus, where when the switching indication is of the first value, the third encoded data carries the first mode indication, the inner-code processing unit 1320 continues to perform receiver inner-code processing on the third encoded data in the first inner-code processing mode; or when the switching indication is of the second value, the third encoded data carries a mode indication indicating a third inner-code processing mode, where receiver inner-code processing is performed on the third encoded data in the third inner-code processing mode, and the third inner-code processing mode is an inner-code processing mode other than the first inner-code processing mode in the plurality of inner-code processing modes.

In a third possible implementation, the communication unit 1310 sends second encoded data to the first optical communication apparatus, where the second encoded data carries a second indication, and the second indication carries the first mode indication and a switching indication; and when the switching indication is of a first value, it indicates that the inner-code processing mode indicated by the first mode indication matches quality that is of a link and that is detected by a second optical communication apparatus; when the switching indication is of a third value, it indicates to switch to an inner-code processing mode whose delay or performance (error correction capability) is greater than that of the first inner-code processing mode; or when the switching indication is of a fourth value, it indicates to switch to an inner-code processing mode whose delay or performance (error correction capability) is less than that of the first inner-code processing mode, where the link is a link for communication between the first optical communication apparatus and the second optical communication apparatus; and

In some embodiments, the communication unit 1310 receives third encoded data from the first optical communication apparatus; and the inner-code processing unit 1320 performs receiver inner-code processing on the third encoded data in a third inner-code processing mode based on the switching indication, where when the switching indication is of the first value, the third inner-code processing mode is the same as the first inner-code processing mode; when the switching indication is of the third value, a delay or performance (an error correction capability) of the third inner-code processing mode is greater than a delay or performance (an error correction capability) of the first inner-code processing mode; or when the switching indication is of the fourth value, a delay or performance (an error correction capability) of the third inner-code processing mode is less than a delay or performance (an error correction capability) of the first inner-code processing mode.

In a fourth possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode; and
the communication unit 1310 sends second encoded data to the first optical communication apparatus, where the second encoded data carries a fourth indication, where
when the inner-code processing mode indicated by the third mode indication matches quality that is of a link and that is detected by a second optical communication apparatus, the fourth indication includes the first mode indication and the third mode indication; or
when the inner-code processing mode indicated by the third mode indication does not match quality that is of a link and that is detected by a second optical communication apparatus, the fourth indication includes the first mode indication and a fourth mode indication, where an inner-code processing mode indicated by the fourth mode indication matches the quality that is of the link and that is detected by the second optical communication apparatus.

In a fifth possible implementation, the first encoded data carries a third indication, the third indication includes the first mode indication, the first inner-code processing mode indicated by the first mode indication is an inner-code processing mode used in a negotiation process, the third indication further includes a third mode indication, and the third mode indication indicates a to-be-negotiated inner-code processing mode; and
the communication unit 1310 sends second encoded data to the first optical communication apparatus, where the second encoded data is obtained by performing transmitter inner-code processing in the first inner-code processing mode, the second encoded data carries a fourth indication, and the fourth indication includes the first mode indication and a determining indication; and when the determining indication is of a first value, it indicates that the third mode indication matches quality that is of a link and that is detected by a second optical communication apparatus; or when the determining indication is of a second value, it indicates that the third mode indication does not match quality that is of a link and that is detected by a second optical communication apparatus, where the link is a link for communication between the first optical communication apparatus and the second optical communication apparatus.

The inner-code processing unit 1320 is further configured to detect the quality of the link between the first optical communication apparatus and the second optical communication apparatus based on the first encoded data, where an inner-code processing mode that matches the quality of the link and that is in the plurality of inner-code processing modes satisfies at least one of the following:
in a process of performing inner decoding on the first encoded data, a determined first quantity of non-zero syndromes in syndromes of N1 consecutive codewords in the first encoded data is within a first quantity range corresponding to the matched inner-code processing mode in the plurality of inner-code processing modes, each of the plurality of inner-code processing modes corresponds to one first quantity range, and different inner-code processing modes correspond to different first quantity ranges, where N1 is an integer greater than 1;
in a process of performing inner decoding on the first encoded data, a determined first proportion of non-zero syndromes in syndromes of N2 consecutive codewords in the first encoded data is within a first proportion range corresponding to the matched inner-code processing mode, each of the plurality of inner-code processing modes corresponds to one first proportion range, and different inner-code processing modes correspond to different first proportion ranges, where N2 is an integer greater than 1;
in a process of performing inner decoding on N3 consecutive bits in the first encoded data, a determined quantity of corrected bits is within a second quantity range corresponding to the matched inner-code processing mode, each of the plurality of inner-code processing modes corresponds to one second quantity range, and different inner-code processing modes correspond to different second quantity ranges, where N3 is an integer greater than 1;
in a process of performing inner decoding on N4 consecutive bits in the first encoded data, a determined second proportion of a quantity of corrected bits to the N3 bits is within a second proportion range corresponding to the matched inner-code processing mode, each of the plurality of inner-code processing modes corresponds to one second proportion range, and different inner-code processing modes correspond to different second proportion ranges, where N4 is an integer greater than 1;
in a process of performing inner decoding on N5 consecutive codewords of the first encoded data, a determined third quantity of error correction-failed codewords is within a third quantity range corresponding to the matched inner-code processing mode, each of the plurality of inner-code processing modes corresponds to one third quantity range, and different inner-code processing modes correspond to different third quantity ranges, where N5 is an integer greater than 1;
in a process of performing inner decoding on N6 consecutive codewords of the first encoded data, a determined third proportion of error correction-failed codewords is within a third proportion range corresponding to the matched inner-code processing mode, each of the plurality of inner-code processing modes corresponds to one third proportion range, and different inner-code processing modes correspond to different third proportion ranges, where N6 is an integer greater than 1;
in a process of performing inner decoding and outer decoding on N7 consecutive codewords of the first encoded data, a determined fourth quantity of error correction-failed codewords is within a fourth quantity range corresponding to the matched inner-code processing mode, each of the plurality of inner-code processing modes corresponds to one fourth quantity range, and different inner-code processing modes correspond to different fourth quantity ranges, where N7 is an integer greater than 1; or
in a process of performing inner decoding and outer decoding on N8 consecutive codewords of the first encoded data, a determined fourth proportion of error correction-failed codewords is within a fourth proportion range corresponding to the matched inner-code processing mode, each of the plurality of inner-code processing modes corresponds to one fourth proportion range, and different inner-code processing modes correspond to different fourth proportion ranges, where N8 is an integer greater than 1.

In a possible implementation, the first encoded data further carries a decoding indication indicating a decoding manner used in the first inner-code processing mode, and the decoding manner is hard decoding or soft decoding; and the receiver inner-code processing includes inner decoding, and the inner decoding uses the decoding manner indicated by the decoding indication.

In a possible implementation, the inner-code processing unit 1320 may include a plurality of modules, such as a convolutional interleaving module, a circular shift module, an inner encoding module, a channel interleaving module, and a PAD module. Each module performs a corresponding operation or does not perform a corresponding operation based on the inner-code processing mode. For example, when the inner-code processing mode is skipping convolutional interleaving, the convolutional interleaving module does not perform a convolutional interleaving operation, and the convolutional interleaving module in the inner-code processing unit 1320 is skipped. For another example, if the inner-code processing mode is skipping circular shift, the circular shift module does not perform a circular shift operation.

In a possible implementation, the inner-code processing unit 1320 for an optical module of a receiver may further include a mode detection module, configured to: detect an inner-code processing mode indicated by a transmitter, for example, detect quality of a current link, determine an adapted inner-code processing mode based on the quality, and then indicate the PAD module to insert, at a corresponding position, a mode indication indicating the inner-code processing mode.

In a possible implementation, the inner-code processing unit 1320 for an optical module of the transmitter may further include a mode control module, configured to: determine a to-be-used inner-code processing mode; and indicate the PAD module to insert, in a corresponding position, a mode indication indicating the inner-code processing mode.

In a possible implementation, the communication unit 1310 may be an input unit and an output unit. An electrical input/output unit and an optical input/output unit may be included. The electrical input/output unit is configured to communicate with a host. The optical input/output unit is configured to communicate with another optical communication device.

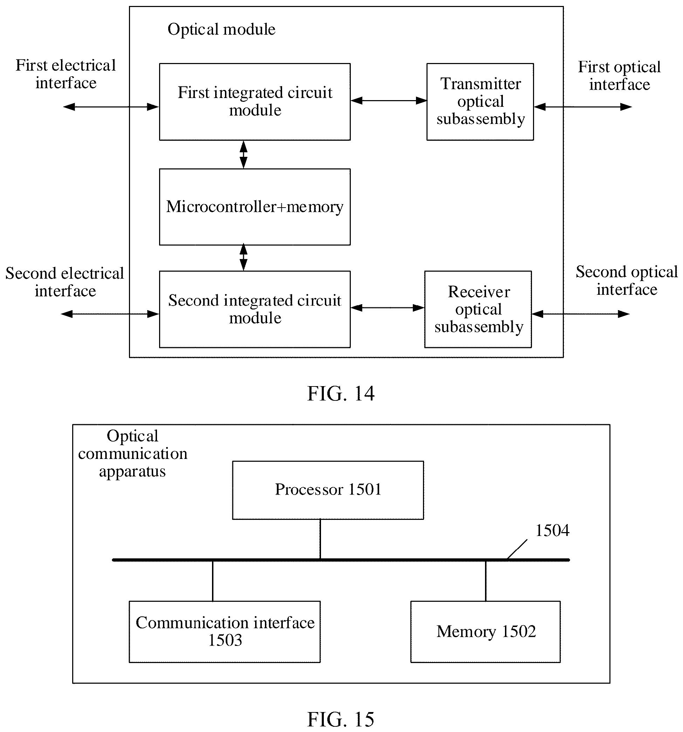

FIG. 14 is a diagram of a structure of another optical module according to an embodiment of this application. The optical module includes a first integrated circuit (integrated circuit, IC) module, a second integrated circuit module, a transmitter optical subassembly (transmitter optical subassembly, TOSA), a receiver optical subassembly (receiver optical subassembly, ROSA), a memory, and a microcontroller (microcontroller unit, MCU). In addition, a first electrical interface, a second electrical interface, a first optical interface, and a second optical interface are disposed on the optical module, the first electrical interface is connected to an input end of the first integrated circuit module, the second electrical interface is connected to an output end of the second integrated circuit module, and the other ends of the first electrical interface and the second electrical interface may be configured to connect to a host. The first optical interface is connected to an output end of the transmitter optical subassembly, and the second optical interface is connected to an input end of the receiver optical subassembly.

The microcontroller is configured to control each component in the optical module. The first integrated circuit module is configured to: receive an electrical signal from the first electrical interface, where the electrical signal includes outer-encoded data; perform transmitter inner-code processing on the electrical signal; and transmit a processed electrical signal to the transmitter optical subassembly. The transmitter optical subassembly is configured to: convert the electrical signal processed by the first integrated circuit module into an optical signal, and perform other processing, and output the converted optical signal through the first optical interface. The receiver optical subassembly is configured to: receive an optical signal (encoded data from a peer-side optical communication device) input from the second optical interface, convert the optical signal into an electrical signal, and perform other processing, and transmit the converted electrical signal to the second integrated circuit. The second integrated circuit is configured to perform receiver inner-code processing on the converted electrical signal, and output a processed electrical signal through the second electrical interface. The memory may be configured to store information such as a performance parameter, vendor information, a device model, and a device version number of the optical module. In addition, the first integrated circuit module includes the inner-code processing unit (used on an encoding side), and the second integrated circuit module includes the inner-code processing unit (used on a decoding side).

In this embodiment of this application, the memory in the optical module may be an electrically erasable programmable read-only memory. In the electrically erasable programmable read-only memory, a correspondence between an identifier of an inner-code processing mode and a mode indication is set, and an identifier of a currently used inner-code processing mode may be further configured. The electrically erasable programmable read-only memory is a read-only memory (read-only memory, ROM) that can be modified by a user, and data recorded in the electrically erasable programmable read-only memory may be erased and rewritten by using a programmable voltage. In addition, a byte (Byte) may be used as a minimum modification unit for modifying data in the electrically erasable programmable read-only memory. Therefore, when data is written to the electrically erasable programmable read-only memory, it is not necessary to wash all the data in the electrically erasable programmable read-only memory. Alternatively, the memory in the optical module may be another memory that can be read and written. This is not specifically limited in embodiments of this application.

An embodiment of this application provides an optical communication apparatus. FIG. 15 provides an example of a possible architectural diagram of an optical communication apparatus. As shown in FIG. 15, the optical communication apparatus may include a processor 1501, a memory 1502, a communication interface 1503, and a bus 1504. In the optical communication apparatus, there may be one or more processors 1501. FIG. 15 shows only one of the processors 1501. Optionally, the processor 1501 may be a central processing unit (central processing unit, CPU). If the optical communication apparatus has a plurality of processors 1501, types of the plurality of processors 1501 may be different or may be the same. Optionally, the plurality of processors of the optical communication apparatus may be further integrated into a multi-core processor.

The memory 1502 stores computer instructions and data, and the memory 1502 may store computer instructions and data required for implementing the method provided in this application. The memory 1502 may be any one or any combination of the following storage media: a non-volatile memory (for example, a read-only memory (read-only memory, ROM), a solid-state drive (solid-state drive, SSD), a hard disk drive (hard disk drive, HDD), or an optical disc), and a volatile memory.

The communication interface 1503 may be any one or any combination of the following devices with a network access function: a network interface (for example, an ethernet interface) and a wireless network interface card.

The communication interface 1503 is configured to perform data communication between the optical communication apparatus and another node or another optical communication apparatus. An example of the bus 1504 is drawn in FIG. 15. The bus 1504 may connect the processor 1501 to the memory 1502 and the communication interface 1503. In this way, through the bus 1504, the processor 1501 may access the memory 1502, and may further exchange data with another node or another optical communication apparatus through the communication interface 1503.

In this application, the optical communication apparatus executes the computer instructions in the memory 1502, to implement the data transmission method provided in this application. In addition, for an implementation process in which the optical communication apparatus executes the computer instructions in the memory 1502 to perform the steps of the method provided in this application, refer to corresponding descriptions in the foregoing method embodiments.

An embodiment of this application further provides a computer-readable storage medium. The computer-readable storage medium is a non-volatile computer-readable storage medium. The computer-readable storage medium includes program instructions. When the program instructions are run on a computer device, the computer device is caused to perform the method according to embodiments of this application.

An embodiment of this application further provides a computer program product including instructions. When the computer program product runs on a computer, the computer is caused to perform the method according to embodiments of this application.

A person skilled in the art should understand that embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, an optical memory, and the like) that include computer-usable program code.

This application is described with reference to the flowcharts and/or block diagrams of the method, the device (system), and the computer program product according to embodiments of this application. It should be understood that computer program instructions may be used to implement each procedure and/or each block in the flowcharts and/or the block diagrams and a combination of a procedure and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more procedures in the flowcharts and/or in one or more blocks in the block diagrams.

It is clear that a person skilled in the art can make various modifications and variations to this application without departing from the scope of this application. This application is intended to cover these modifications and variations of this application provided that they fall within the scope of the claims of this application and their equivalent technologies.

## Claims

1. A data transmission method, applied to a first optical communication apparatus, wherein the method comprises:
obtaining outer-encoded first data, wherein the first data is any data in a to-be-sent data stream;
determining a first inner-code processing mode, wherein the first inner-code processing mode is one of a plurality of configured inner-code processing modes, and different inner-code processing modes in the plurality of inner-code processing modes have different processing manners; and
performing transmitter inner-code processing on the first data in the first inner-code processing mode, to obtain first encoded data, and outputting the first encoded data, wherein the first encoded data carries a first mode indication indicating the first inner-code processing mode, and the transmitter inner-code processing corresponding to the first inner-code processing mode comprises at least inner encoding and pad processing.

2. The method according to claim 1, wherein the first mode indication is carried in a pad sequence of the first encoded data.

3. The method according to claim 1 or 2, wherein the pad sequence of the first encoded data carries N first mode indications, and N is an integer greater than 1.

4. The method according to any one of claims 1 to 3, wherein in the plurality of inner-code processing modes, there are at least two inner-code processing modes that satisfy at least one of the following:
convolutional interleaving depths in the two inner-code processing modes are different;
only one of the two inner-code processing modes comprises convolutional interleaving;
one of the two inner-code processing modes comprises circular shift, and the other inner-code processing mode does not comprise the circular shift; or
one of the two inner-code processing modes indicates to perform first inner-code processing, and the other inner-code processing mode indicates to skip the first inner-code processing, wherein the first inner-code processing comprises at least inner encoding and pad processing, and the first inner-code processing mode is not the inner-code processing mode that indicates to skip the first inner-code processing.

5. The method according to any one of claims 1 to 4, wherein the transmitter inner-code processing corresponding to the first inner-code processing mode comprises at least the pad processing and channel interleaving, and the pad processing comprises addition of the first mode indication, wherein
the pad processing is after the channel interleaving; or
the pad processing is before the channel interleaving, wherein the first data comprises data of a plurality of lanes; and when the pad processing is performed on the data of the plurality of lanes before the channel interleaving, the first mode indication is added to data of each lane in the data of the plurality of lanes.

6. The method according to any one of claims 1 to 5, wherein the method further comprises:
receiving second encoded data from a second optical communication apparatus, wherein the second encoded data carries a second mode indication, a second inner-code processing mode indicated by the second mode indication matches quality that is of a link and that is detected by the second optical communication apparatus, and the link is a link for communication between the first optical communication apparatus and the second optical communication apparatus; and
performing, in the second inner-code processing mode, transmitter inner-code processing on outer-encoded third data in the data stream.

7. The method according to claim 6, wherein the method further comprises:
after receiving the second encoded data from the second optical communication apparatus, performing receiver inner-code processing on the second encoded data in the second inner-code processing mode, to obtain second data.

8. The method according to claim 6, wherein the method further comprises:
after receiving the second encoded data from the second optical communication apparatus, performing receiver inner-code processing on the second encoded data in the inner-code processing mode indicated by the first mode indication, to obtain second data.

9. The method according to claim 8, wherein the second encoded data carries a first indication, and the first indication comprises the first mode indication indicating the inner-code processing mode used before switching and the second mode indication indicating the inner-code processing mode used after the switching.

10. The method according to any one of claims 1 to 5, wherein the method further comprises:
receiving second encoded data from a second optical communication apparatus, wherein the second encoded data carries a second indication, and the second indication carries the first mode indication and a switching indication; and when the switching indication is of a first value, it indicates that the first inner-code processing mode matches quality that is of a link and that is detected by the second optical communication apparatus; or when the switching indication is of a second value, it indicates that the first inner-code processing mode does not match quality that is of a link and that is detected by the second optical communication apparatus, wherein the link is a link for communication between the first optical communication apparatus and the second optical communication apparatus; and
performing, in a third inner-code processing mode based on the switching indication, transmitter inner-code processing on outer-encoded third data in the data stream, wherein
when the switching indication is of the first value, the third inner-code processing mode is the first inner-code processing mode; or when the switching indication is of the second value, the third inner-code processing mode is an inner-code processing mode other than the first inner-code processing mode in the plurality of inner-code processing modes.

11. The method according to any one of claims 1 to 5, wherein the first encoded data carries a third indication, the third indication comprises the first mode indication, the first inner-code processing mode indicated by the first mode indication is an inner-code processing mode used in a negotiation process, the third indication further comprises a third mode indication, and the third mode indication indicates a to-be-negotiated inner-code processing mode; and
the method further comprises:
receiving second encoded data from a second optical communication apparatus, wherein the second encoded data carries a fourth indication, wherein
when the inner-code processing mode indicated by the third mode indication matches quality that is of a link and that is detected by the second optical communication apparatus, the fourth indication comprises the first mode indication and the third mode indication, and transmitter inner-code processing is performed, in the inner-code processing mode indicated by the third mode indication, on outer-encoded third data in the data stream; or
when the inner-code processing mode indicated by the third mode indication does not match quality that is of a link and that is detected by the second optical communication apparatus, the fourth indication comprises the first mode indication and a fourth mode indication, wherein an inner-code processing mode indicated by the fourth mode indication matches the quality that is of the link and that is detected by the second optical communication apparatus; and transmitter inner-code processing is performed on outer-encoded third data in the inner-code processing mode indicated by the fourth mode indication.

12. The method according to any one of claims 1 to 5, wherein the first encoded data carries a third indication, the third indication comprises the first mode indication, the first inner-code processing mode indicated by the first mode indication is an inner-code processing mode used in a negotiation process, the third indication further comprises a third mode indication, and the third mode indication indicates a to-be-negotiated inner-code processing mode; and
the method further comprises:
receiving second data from a second optical communication apparatus, wherein the second data carries a fourth indication, and the fourth indication comprises the first mode indication and a determining indication; and when the determining indication is of a first value, it indicates that the inner-code processing mode indicated by the third mode indication matches quality that is of a link and that is detected by the second optical communication apparatus; or when the determining indication is of a second value, it indicates that the inner-code processing mode indicated by the third mode indication does not match quality that is of a link and that is detected by the second optical communication apparatus, wherein the link is a link for communication between the first optical communication apparatus and the second optical communication apparatus; and
performing transmitter inner-code processing on the third data in a third inner-code processing mode based on the determining indication, wherein
when the determining indication is of the first value, the third inner-code processing mode is the inner-code processing mode indicated by the third mode indication; or when the determining indication is of the second value, the third inner-code processing mode is an inner-code processing mode other than the third inner-code processing mode in the plurality of inner-code processing modes.

13. The method according to any one of claims 1 to 12, wherein the first encoded data further carries a decoding indication indicating a decoding manner used in the first inner-code processing mode, and the decoding manner is hard decoding or soft decoding.

14. The method according to any one of claims 1 to 13, wherein the first optical communication apparatus and the second optical communication apparatus are both optical modules.

15. The method according to any one of claims 1 to 14, wherein the first optical communication apparatus comprises a first host and a first optical module, and the method further comprises:
obtaining, by the first host, fourth data from the to-be-sent data stream;
performing, by the first host, outer encoding on the fourth data to obtain outer-encoded fourth data, and sending the outer-encoded fourth data to the first optical module; and
skipping, by the first optical module, the transmitter inner-code processing on the outer-encoded fourth data, and outputting the outer-encoded fourth data.

16. The method according to claim 15, wherein the outer-encoded fourth data carries a fourth mode indication indicating a fourth inner-code processing mode, and the fourth inner-code processing mode indicates the first optical module to skip the transmitter inner-code processing.

17. A data transmission method, applied to a second optical communication apparatus, wherein the method comprises:
receiving first encoded data from a first optical communication apparatus, wherein the first encoded data carries a first mode indication, a first inner-code processing mode indicated by the first mode indication is one of a plurality of configured inner-code processing modes, and different inner-code processing modes in the plurality of inner-code processing modes have different processing manners; and
performing receiver inner-code processing on the first encoded data in the first inner-code processing mode, to obtain first data.

18. The method according to claim 17, wherein the first mode indication is carried in a pad sequence of the first encoded data.

19. The method according to claim 17 or 18, wherein the pad sequence of the first encoded data carries N first mode indications, and N is an integer greater than 1.

20. The method according to any one of claims 17 to 19, wherein in the plurality of inner-code processing modes, there are at least two inner-code processing modes that satisfy at least one of the following:
convolutional interleaving depths in the two inner-code processing modes are different;
only one of the two inner-code processing modes comprises convolutional interleaving;
one of the two inner-code processing modes comprises circular shift, and the other inner-code processing mode does not comprise the circular shift; or
one of the two inner-code processing modes indicates to perform first inner-code processing, and the other inner-code processing mode indicates to skip the first inner-code processing, wherein the first inner-code processing comprises at least inner encoding and pad processing, and the first inner-code processing mode is not the inner-code processing mode that indicates to skip the first inner-code processing.

21. The method according to any one of claims 17 to 20, wherein the receiver inner-code processing corresponding to the first inner-code processing mode comprises at least de-pad processing and channel de-interleaving, and the de-pad processing comprises detection of the first mode indication, wherein
the de-pad processing is before the channel de-interleaving; or
the de-pad processing is after the channel de-interleaving, wherein in a de-pad processing process, the first mode indication is detected in data of a plurality of lanes that is obtained through the channel de-interleaving.

22. The method according to any one of claims 17 to 21, wherein the method further comprises:
sending second encoded data to the first optical communication apparatus, wherein the second encoded data carries a second mode indication, a second inner-code processing mode indicated by the second mode indication matches quality that is of a link and that is detected by the second optical communication apparatus, and the link is a link for communication between the first optical communication apparatus and the second optical communication apparatus;
receiving third encoded data from the first optical communication apparatus; and
performing receiver inner-code processing on the third encoded data in the second inner-code processing mode.

23. The method according to claim 22, wherein the second encoded data carries a first indication, and the first indication comprises the first mode indication indicating the inner-code processing mode used before switching and the second mode indication indicating the inner-code processing mode used after the switching.

24. The method according to any one of claims 17 to 21, wherein the method further comprises:
sending second encoded data to the first optical communication apparatus, wherein the second encoded data carries a second indication, and the second indication carries the first mode indication and a switching indication; and when the switching indication is of a first value, it indicates that the inner-code processing mode indicated by the first mode indication matches quality that is of a link and that is detected by the second optical communication apparatus; or when the switching indication is of a second value, it indicates that the first mode indication does not match quality that is of a link and that is detected by the second optical communication apparatus, wherein the link is a link for communication between the first optical communication apparatus and the second optical communication apparatus.

25. The method according to claim 24, wherein the method further comprises:
receiving third encoded data from the first optical communication apparatus, wherein
when the switching indication is of the first value, the third encoded data carries the first mode indication, and receiver inner-code processing is performed on the third encoded data still in the first inner-code processing mode; or
when the switching indication is of the second value, the third encoded data carries a mode indication indicating a third inner-code processing mode, and receiver inner-code processing is performed on the third encoded data in the third inner-code processing mode, wherein the third inner-code processing mode is an inner-code processing mode other than the first inner-code processing mode in the plurality of inner-code processing modes.

26. The method according to any one of claims 17 to 21, wherein the method further comprises:
sending second encoded data to the first optical communication apparatus, wherein the second encoded data carries a second indication, and the second indication carries the first mode indication and a switching indication; and when the switching indication is of a first value, it indicates that the inner-code processing mode indicated by the first mode indication matches quality that is of a link and that is detected by the second optical communication apparatus; when the switching indication is of a third value, it indicates to switch to an inner-code processing mode whose delay is greater than that of the first inner-code processing mode; or when the switching indication is of a fourth value, it indicates to switch to an inner-code processing mode whose delay is less than that of the first inner-code processing mode, wherein the link is a link for communication between the first optical communication apparatus and the second optical communication apparatus.

27. The method according to any one of claims 17 to 21, wherein the first encoded data carries a third indication, the third indication comprises the first mode indication, the first inner-code processing mode indicated by the first mode indication is an inner-code processing mode used in a negotiation process, the third indication further comprises a third mode indication, and the third mode indication indicates a to-be-negotiated inner-code processing mode; and
sending second encoded data to the first optical communication apparatus, wherein the second encoded data carries a fourth indication, wherein
when the inner-code processing mode indicated by the third mode indication matches quality that is of a link and that is detected by the second optical communication apparatus, the fourth indication comprises the first mode indication and the third mode indication; or
when the inner-code processing mode indicated by the third mode indication does not match quality that is of a link and that is detected by the second optical communication apparatus, the fourth indication comprises the first mode indication and a fourth mode indication, and an inner-code processing mode indicated by the fourth mode indication matches the quality that is of the link and that is detected by the second optical communication apparatus.

28. The method according to any one of claims 17 to 21, wherein the first encoded data carries a third indication, the third indication comprises the first mode indication, the first inner-code processing mode indicated by the first mode indication is an inner-code processing mode used in a negotiation process, the third indication further comprises a third mode indication, and the third mode indication indicates a to-be-negotiated inner-code processing mode; and
the method further comprises:
sending second encoded data to the first optical communication apparatus, wherein the second encoded data is obtained by performing transmitter inner-code processing in the first inner-code processing mode, the second encoded data carries a fourth indication, and the fourth indication comprises the first mode indication and a determining indication; and when the determining indication is of a first value, it indicates that the third mode indication matches quality that is of a link and that is detected by the second optical communication apparatus; or when the determining indication is of a second value, it indicates that the third mode indication does not match quality that is of a link and that is detected by the second optical communication apparatus, wherein the link is a link for communication between the first optical communication apparatus and the second optical communication apparatus.

29. The method according to any one of claims 22 to 28, wherein the method further comprises:
detecting the quality of the link between the first optical communication apparatus and the second optical communication apparatus based on the first encoded data, wherein an inner-code processing mode that matches the quality of the link and that is in the plurality of inner-code processing modes satisfies at least one of the following:
in a process of performing inner decoding on the first encoded data, a determined first quantity of non-zero syndromes in syndromes of N1 consecutive codewords in the first encoded data is within a first quantity range corresponding to the matched inner-code processing mode in the plurality of inner-code processing modes, each of the plurality of inner-code processing modes corresponds to one first quantity range, and different inner-code processing modes correspond to different first quantity ranges, wherein N1 is an integer greater than 1;
in a process of performing inner decoding on the first encoded data, a determined first proportion of non-zero syndromes in syndromes of N2 consecutive codewords in the first encoded data is within a first proportion range corresponding to the matched inner-code processing mode, each of the plurality of inner-code processing modes corresponds to one first proportion range, and different inner-code processing modes correspond to different first proportion ranges, wherein N2 is an integer greater than 1;
in a process of performing inner decoding on N3 consecutive bits in the first encoded data, a determined quantity of corrected bits is within a second quantity range corresponding to the matched inner-code processing mode, each of the plurality of inner-code processing modes corresponds to one second quantity range, and different inner-code processing modes correspond to different second quantity ranges, wherein N3 is an integer greater than 1;
in a process of performing inner decoding on N4 consecutive bits in the first encoded data, a determined second proportion of a quantity of corrected bits to the N4 bits is within a second proportion range corresponding to the matched inner-code processing mode, each of the plurality of inner-code processing modes corresponds to one second proportion range, and different inner-code processing modes correspond to different second proportion ranges, wherein N4 is an integer greater than 1;
in a process of performing inner decoding on N5 consecutive codewords of the first encoded data, a determined third quantity of error correction-failed codewords is within a third quantity range corresponding to the matched inner-code processing mode, each of the plurality of inner-code processing modes corresponds to one third quantity range, and different inner-code processing modes correspond to different third quantity ranges, wherein N5 is an integer greater than 1;
in a process of performing inner decoding on N6 consecutive codewords of the first encoded data, a determined third proportion of error correction-failed codewords is within a third proportion range corresponding to the matched inner-code processing mode, each of the plurality of inner-code processing modes corresponds to one third proportion range, and different inner-code processing modes correspond to different third proportion ranges, wherein N6 is an integer greater than 1;
in a process of performing inner decoding and outer decoding on N7 consecutive codewords of the first encoded data, a determined fourth quantity of error correction-failed codewords is within a fourth quantity range corresponding to the matched inner-code processing mode, each of the plurality of inner-code processing modes corresponds to one fourth quantity range, and different inner-code processing modes correspond to different fourth quantity ranges, wherein N7 is an integer greater than 1; or
in a process of performing inner decoding and outer decoding on N8 consecutive codewords of the first encoded data, a determined fourth proportion of error correction-failed codewords is within a fourth proportion range corresponding to the matched inner-code processing mode, each of the plurality of inner-code processing modes corresponds to one fourth proportion range, and different inner-code processing modes correspond to different fourth proportion ranges, wherein N8 is an integer greater than 1.

30. The method according to any one of claims 17 to 29, wherein the first encoded data further carries a decoding indication indicating a decoding manner used in the first inner-code processing mode, and the decoding manner is hard decoding or soft decoding; and
the receiver inner-code processing comprises inner decoding, and the inner decoding uses the decoding manner indicated by the decoding indication.

31. The method according to any one of claims 17 to 30, wherein the first optical communication apparatus and the second optical communication apparatus are both optical modules.

32. The method according to any one of claims 17 to 31, wherein the method further comprises:
receiving fourth data from the second optical communication apparatus, and detecting a rate of the fourth data; and
when it is determined, based on the rate of the fourth data, that a used inner-code processing mode indicates to skip receiver inner-code processing, skipping the receiver inner-code processing on the fourth data.

33. An optical module, comprising a communication unit and an inner-code processing unit, wherein
the communication unit is configured to send and receive data; and
the inner-code processing unit is configured to perform the method according to any one of claims 1 to 13, or perform the method according to any one of claims 17 to 30.

34. An optical communication apparatus, comprising a memory and a processor, wherein the memory stores program code, and the processor is configured to run the program code to perform the method according to any one of claims 1 to 16, or perform the method according to any one of claims 17 to 32.

35. An optical communication system, comprising a first optical communication apparatus and a second optical communication apparatus, wherein
the first optical communication apparatus is configured to perform the method according to any one of claims 1 to 16; and
the second optical communication apparatus is configured to perform the method according to any one of claims 17 to 32.

36. A computer-readable storage medium, storing program instructions, wherein when the program instructions are executed on a processor, the processor is caused to perform the method according to any one of claims 1 to 16, or perform the method according to any one of claims 17 to 32.
